# FASCICULE DE BREVET EUROPEEN

(11) **EP 3 893 281 B1**
(45) Date de publication et mention de la délivrance du brevet: **10.08.2022**
(21) Numéro de dépôt: 21166778.7
(22) Date de dépôt: 01.04.2021
(51) Int. Cl.: H01L 27/15, H01L 33/38, H01L 27/146

(54) **DISPOSITIF A MATRICE DE DIODES PHOTO-EMETTRICES ET/OU PHOTO-RECEPTRICES**
LICHTEMITTIERENDE UND/ODER LICHTEMPFANGENDE DIODENARRAY-VORRICHTUNG
DEVICE WITH ARRAY OF LIGHT-EMITTING AND/OR LIGHT-RECEIVING DIODES

(30) Priorité: 06.04.2020 FR 2003427
(43) Date de publication de la demande: 13.10.2021
(73) Titulaire: Commissariat à l'énergie atomique et aux énergies alternatives, 75015 Paris (FR)
(72) Inventeur: GASSE, Adrien, 38054 Grenoble CEDEX 09 (FR); DUPRE, Ludovic, 38054 GRENOBLE CEDEX 09 (FR); CONSONNI, Marianne, 38054 GRENOBLE CEDEX 09 (FR)
(74) Mandataire: Brevalex

(56) Documents cités:
- EP-A1- 3 624 192
- WO-A1-2016/060676
- WO-A1-2017/068029
- US-A1- 2016 043 119
- US-A1- 2019 043 901
- US-A1- 2019 355 786
- US-B1- 10 204 950

## Description

### DOMAINE TECHNIQUE

L'invention concerne le domaine des dispositifs à diodes photo-émettrices, telles que des diodes électroluminescentes (appelées DELs ou LEDs, ou encore micro-LEDs), et/ou à diodes photo-réceptrices telles que des photodiodes. L'invention s'applique notamment aux domaines suivants :
- dispositifs d'éclairage par LEDs, dispositifs électroniques comprenant des matrices de LEDs tels que des écrans, des projecteurs, des murs d'images, ou des dispositifs d'éclairage comme par exemple des phares pour véhicule ;
- dispositifs électroniques ou microélectroniques photorécepteurs comportant des matrices de photodiodes, tels que des capteurs d'images ;
- dispositifs comportant à la fois des diodes photo-émettrices et des diodes photo-réceptrices, formant par exemple à la fois un capteur et un écran.

### ÉTAT DE LA TECHNIQUE ANTÉRIEURE

Dans un dispositif à diodes photo-émettrices et/ou photo-réceptrices, il est souvent avantageux d'augmenter la résolution du dispositif, c'est-à-dire d'augmenter le nombre de cellules actives, ou pixels, par unité de surface du dispositif. Cette augmentation de la résolution implique de diminuer la taille unitaire des pixels tout en essayant de ne pas augmenter la diaphonie (ou en « cross-talk » en anglais), c'est-à-dire les interférences optiques se produisant entre pixels adjacents et de minimiser la diminution de performances des diodes généralement observée sur les petits pixels.

Le document FR 3 042 913 décrit une technologie de fabrication de matrices de diodes photo-émettrices et/ou photo-réceptrices dans laquelle les pixels sont réalisés de manière auto-alignée à l'aide d'un unique niveau de lithographie permettant à la fois de séparer physiquement les différentes diodes en créant des structures en mesa, et de prendre le contact électrique de la portion dopée N de chaque diode uniquement par un contact avec les flancs latéraux de cette portion. Avec cette technique, chaque diode photo-émettrice et/ou photo-réceptrice est définie par la taille de la structure en mesa fabriquée et les tranchées gravées traversent toute l'épaisseur de semi-conducteur épitaxié pour former les diodes, jusqu'au substrat.

Cette gravure définissant les pixels provoque des défauts dans le matériau semi-conducteur car elle endommage tous les flancs latéraux des structures mesa, provoquant ainsi une diminution des performances, notamment l'efficacité quantique externe (EQE), des diodes photo-émettrices et/ou photo-réceptrices lorsque leur taille diminue.

De plus, le procédé proposé dans le document FR 3 042 913 ne permet pas la réalisation de matrice de diodes photo-émettrices et/ou photo-réceptrices avec une densité de diodes variable au sein de la matrice tout en conservant une performance homogène sur toute la surface de la matrice.

Le document US 2019/0355786 A1 divulgue un dispositif comprenant une matrice de pixels groupés dans lesquels une connexion à une première couche semi-conductrice commune à tous les pixels est formée dans une tranché formée au moins à travers une deuxième couche semi-conductrice. Chaque photo-diode comprend des électrodes disposées à la même surface dudit dispositif. Le dispositif selon le document US 2019/0355786 A1 comprend en outre des tranchées d'isolation optique entre des groupes de pixels, lesdites tranchées d'isolation optiques étant remplies d'un matériau réflecteur. Ledit matériau réflecteur et la connexion à une première couche semi-conductrice peuvent être formés du même matériau conducteur. Des dispositifs à matrice de diodes sont aussi connus des documents WO 2017/068029 A1, US 2016/043119 A1, US 10 204 950 B1, EP 3 624 192 A1, US 2019/043901 A1 et WO 2016/060676 A1.

Les procédés technologiques de fabrication mis en jeu ne sont en outre que peu compatibles avec des variations de densité de motifs au sein de la matrice.

### EXPOSÉ DE L'INVENTION

Un but de la présente invention est de proposer un dispositif à matrice de diodes photo-émettrices et/ou photo-réceptrices dont la structure permet une réalisation en limitant l'endommagement des flancs latéraux des diodes, et qui soit compatible avec une densité de diodes variable au sein de la matrice.

Pour cela, l'invention propose un dispositif à matrice de diodes photo-émettrices et/ou photo-réceptrices, formant une matrice de pixels du dispositif, comportant au moins :
- un empilement d'au moins une première et une deuxième couches de semi-conducteurs dopés selon des types de conductivité différents, chacune des diodes comportant une portion de la première couche superposée à une portion de la deuxième couche ;
- des premières tranchées traversant toute l'épaisseur de la deuxième couche et au moins une partie de l'épaisseur de la première couche et entourant au moins une région de l'empilement dans laquelle sont formées plusieurs diodes ;
- des portions diélectriques disposées dans les premières tranchées et recouvrant des flancs latéraux de ladite région de l'empilement sur toute l'épaisseur de la deuxième couche et une première partie de l'épaisseur de la première couche ;
- des premières portions électriquement conductrices disposées dans les premières tranchées, recouvrant les flancs latéraux de ladite région de l'empilement sur une deuxième partie de l'épaisseur de la première couche non recouverte par les portions diélectriques et/ou recouvrant des parois de fond des premières tranchées, et formant au moins une partie de premières électrodes des diodes formées dans ladite région de l'empilement ;
- au moins une deuxième tranchée traversant partiellement l'épaisseur de la première couche depuis une face opposée à celle se trouvant en regard de la deuxième couche, c'est-à-dire depuis une première face de la première couche opposée à une deuxième face de la première couche se trouvant en regard de la deuxième couche, et séparant les portions de la première couche des diodes formées dans ladite région de l'empilement sans traverser l'interface entre les première et deuxième couches ;
- plusieurs deuxièmes électrodes isolées électriquement les unes des autres et chacune reliée électriquement à l'une des portions de la deuxième couche des diodes formées dans ladite région de l'empilement.

Les portions de la deuxième couche des diodes formées dans ladite région de l'empilement forment une portion de semi-conducteur continue qui n'est pas traversée par les premières et deuxième tranchées.

Dans un tel dispositif, les flancs latéraux des diodes définis par la ou les deuxièmes tranchées ne sont pas endommagés au niveau de l'interface entre les première et deuxième couches puisque la ou les deuxièmes tranchées ne traversent pas cette interface (les deuxièmes tranchées ne traversent qu'une partie de l'épaisseur de la première couche). La diminution des performances des diodes photo-émettrices et/ou photo-réceptrices engendrée par les premières tranchées est donc moindre, voire nulle, par rapport à celle observée lorsque tous les flancs latéraux de toutes les diodes de la matrice sont gravés sur toute l'épaisseur de l'empilement de couches à partir duquel les diodes sont réalisées.

Les deuxièmes tranchées ne traversent pas l'interface entre les première et deuxième couches afin de ne pas endommager les flancs latéraux des diodes définies par les deuxièmes tranchées. Autrement dit, les parties de cette interface se trouvant en regard, ou à l'aplomb, des deuxièmes tranchées ne sont pas traversées par ces deuxièmes tranchées ni par d'autres tranchées. De plus, les premières tranchées entourent au moins une région de l'empilement dans laquelle sont formées plusieurs diodes et ces diodes ne sont pas séparées les unes des autres par les premières tranchées.

Ainsi, la structure proposée ici permet, grâce aux deuxièmes tranchées, de réduire ou même supprimer la dépendance de l'EQE des diodes de la matrice en fonction de la taille des diodes.

De plus, cette structure permet également de moduler aisément la résolution au sein de la matrice de pixels puisque la résolution initiale de la matrice définie par les premières tranchées peut être modifiée localement dans une ou plusieurs régions de la matrice en définissant des diodes de plus petites dimensions via la réalisation de la ou des deuxièmes tranchées.

Ici et dans tout le reste du document, le terme « diode » est utilisé pour désigner une diode photo-émettrice, comme par exemple une LED, ou une diode photo-réceptrice, comme par exemple une photodiode.

Les semi-conducteurs des première et deuxième couches sont dopés selon des types de conductivité différents, c'est-à-dire que l'une des première et deuxième couches comporte un semi-conducteur dopé de type p et que l'autre des première et deuxième couches comporte un semi-conducteur dopé de type n.

Dans la définition ci-dessus du dispositif, la première partie de l'épaisseur de la première couche est disposée entre la deuxième couche et la deuxième partie de l'épaisseur de la première couche.

Bien que la ou les deuxièmes tranchées ne traversent pas la deuxième couche et ne traverse pas l'interface entre les première et deuxième couches, cette ou ces deuxièmes tranchées assurent une isolation optique entre les diodes dont les portions de la première couche sont séparées par cette ou ces deuxièmes tranchées.

Le dispositif peut comporter en outre au moins une deuxième portion électriquement conductrice disposée dans la deuxième tranchée. La présence de cette deuxième portion électriquement conductrice dans la deuxième tranchée améliore l'isolation optique entre les pixels dont les portions de la première couche sont séparées par cette deuxième tranchée.

De plus, la deuxième portion électriquement conductrice peut être couplée électriquement aux premières portions électriquement conductrices et former, avec les premières portions électriquement conductrices, les premières électrodes des diodes. Ce couplage électrique entre la ou les deuxièmes portions électriquement conductrices et les premières portions électriquement conductrices est par exemple obtenu en réalisant les premières et deuxièmes tranchées selon des motifs qui se croisent ou se superposent à certains endroits.

Le matériau de la ou des deuxièmes portions électriquement conductrices peut être avantageusement optiquement réflecteur. Ainsi, lorsque les diodes correspondent à des diodes photo-émissives, la présence de ce matériau optiquement réflecteur améliore l'extraction de la lumière émise par les diodes. Lorsque les diodes correspondent à des diodes photo-réceptrices, la présence de ce matériau optiquement réflecteur évite, au niveau d'un pixel, la dispersion du rayonnement reçu dans les pixels voisins. Que les diodes soient photo-émissives ou photo-réceptrices, la présence d'un tel matériau limite donc la diaphonie entre les diodes voisines.

Les premières tranchées et les premières portions électriquement conductrices peuvent traverser toute l'épaisseur de l'empilement, ou toute l'épaisseur de la deuxième couche et une partie seulement de l'épaisseur de la première couche.

Dans une configuration particulière :
- toutes les diodes de la matrice peuvent être formées dans ladite région de l'empilement, et
- chacune des diodes de la matrice peut être séparée d'une ou plusieurs diodes voisines par au moins une des deuxièmes tranchées.

Cette configuration est très avantageuse car aucun flanc latéral des diodes de la matrice n'est endommagé (ceux se trouvant en périphérie de la matrice peuvent par exemple faire partie de pixels non fonctionnels ou non utilisés, appelés alors pixels mécaniques). Les performances des diodes de la matrice sont donc très bonnes, similaires ou identiques à des diodes de taille égale aux dimensions totales de la matrice. Selon une autre configuration :
- les premières tranchées peuvent entourer plusieurs régions de l'empilement dans lesquelles les diodes de la matrice sont formées, et
- une ou plusieurs de ces régions peuvent comporter chacune la deuxième tranchée ou plusieurs deuxièmes tranchées.

Cette autre configuration peut notamment être utilisée lorsque la matrice de diodes est réalisée avec différentes régions présentant des résolutions de pixels différentes. Dans cette configuration, les premières tranchées peuvent définir la résolution minimale au sein de la matrice, et la ou les deuxièmes tranchées peuvent être formées dans une ou plusieurs régions de la matrice où la résolution des pixels est plus importante.

La ou les régions de l'empilement comportant la ou les deuxièmes tranchées (celles ayant une résolution plus importante) peuvent former une partie centrale de la matrice de diodes.

Le dispositif peut comporter en outre un circuit électronique de contrôle sur lequel l'empilement des première et deuxième couches est disposé et auquel les premières et deuxièmes électrodes des diodes sont couplées électriquement.

Le dispositif peut être tel que :
- les diodes correspondent à des photodiodes, l'empilement comportant en outre au moins une couche de semi-conducteur intrinsèque ou non intentionnellement dopé disposée entre les première et deuxième couches et telle que des flancs latéraux de la couche de semi-conducteur intrinsèque présents dans les premières tranchées soient recouverts par les portions diélectriques, les deuxièmes tranchées ne traversant pas la couche de semi-conducteur intrinsèque, ou
- les diodes correspondent à des LED, l'empilement comportant au moins une couche émissive à puits quantique disposée entre les première et deuxième couches et telle que des flancs latéraux de la couche émissive présents dans les premières tranchées soient recouverts par les portions diélectriques, les deuxièmes tranchées ne traversant pas la couche émissive.

Les deuxièmes tranchées ne traversent pas la couche de semi-conducteur intrinsèque ou la couche émissive et ne provoquent donc pas de défaut dans cette couche.

L'invention concerne également un procédé de réalisation d'un dispositif à matrice de diodes photo-émettrices et/ou photo-réceptrices, comportant au moins les étapes de :
- réalisation d'un empilement d'au moins une première et une deuxième couches de semi-conducteurs dopés selon des types de conductivité différents, chacune des diodes étant destinée à comporter une portion de la première couche superposée à une portion de la deuxième couche ;
- réalisation de plusieurs deuxièmes électrodes isolées électriquement les unes des autres et chacune reliée électriquement à l'une des portions de la deuxième couche des diodes destinées à être formées dans ladite région de l'empilement ;
- réalisation de premières tranchées traversant toute l'épaisseur de la deuxième couche et au moins une partie de l'épaisseur de la première couche et entourant au moins une région de l'empilement dans laquelle plusieurs diodes sont destinées à être formées ;
- réalisation de portions diélectriques disposées dans les premières tranchées et recouvrant des flancs latéraux de ladite région de l'empilement sur toute l'épaisseur de la deuxième couche et une première partie de l'épaisseur de la première couche ;
- réalisation de premières portions électriquement conductrices disposées dans les premières tranchées, recouvrant les flancs latéraux de ladite région de l'empilement sur une deuxième partie de l'épaisseur de la première couche non recouverte par les portions diélectriques et/ou recouvrant des parois de fond des premières tranchées, et formant au moins une partie de premières électrodes des diodes destinées à être formées dans ladite région de l'empilement ;
- réalisation d'au moins une deuxième tranchée traversant partiellement l'épaisseur de la première couche depuis une face opposée à celle se trouvant en regard de la deuxième couche, c'est-à-dire depuis une première face de la première couche opposée à une deuxième face de la première couche se trouvant en regard de la deuxième couche, et séparant les portions de la première couche des diodes formées dans ladite région de l'empilement sans traverser l'interface entre les première et deuxième couches ;
et dans lequel les portions de la deuxième couche des diodes formées dans ladite région de l'empilement forment une portion de semi-conducteur continue qui n'est pas traversée par les premières et deuxième tranchées.

Dans le procédé ci-dessus, l'ordre de mise en œuvre des étapes ne correspond pas nécessairement à l'ordre dans lequel ces étapes sont énumérées ci-dessus.

L'empilement peut être réalisé par épitaxie sur un substrat tel que la première couche soit disposée entre le substrat et la deuxième couche.

Selon un premier mode de réalisation, les premières tranchées, les portions diélectriques et les premières portions électriquement conductrices peuvent être réalisées en mettant en œuvre les étapes suivantes :
- après la réalisation des deuxièmes électrodes, première gravure de l'empilement à travers la deuxième couche et la première partie de l'épaisseur de la première couche, selon un motif définissant les premières tranchées, formant des premières parties des premières tranchées, puis
- réalisation des portions diélectriques recouvrant les flancs latéraux des premières parties des premières tranchées, puis
- deuxième gravure de l'empilement à travers au moins une partie d'une épaisseur restante de la première couche et selon le motif définissant les premières tranchées, achevant la réalisation des premières tranchées, puis
- dépôt d'au moins un matériau électriquement conducteur dans les premières tranchées, formant les premières portions électriquement conductrices.

De plus, le procédé peut comporter en outre, après la réalisation des premières portions électriquement conductrices et avant la réalisation de la deuxième tranchée, la mise en œuvre des étapes suivantes :
- solidarisation de l'empilement à un support tel que l'empilement soit disposé entre le substrat et le support, puis
- retrait du substrat.

Après la réalisation de la deuxième tranchée, il est possible de déposer un matériau électriquement conducteur dans la deuxième tranchée, ce matériau électriquement conducteur formant au moins une deuxième portion électriquement conductrice disposée dans la deuxième tranchée.

Dans le premier mode de réalisation, après le retrait du substrat et lorsque la deuxième gravure de l'empilement n'est réalisée qu'à travers une partie seulement de l'épaisseur restante de la première couche, il est possible de mettre en œuvre un amincissement de la première couche depuis la face de la première couche auparavant disposée contre le substrat. Cet amincissement est par exemple arrêté sur les premières portions électriquement conductrices.

Selon un deuxième mode de réalisation, les premières tranchées, les portions diélectriques, les premières portions électriquement conductrices et la deuxième tranchée peuvent être réalisées en mettant en œuvre les étapes suivantes :
- après la réalisation des deuxièmes électrodes, première gravure de l'empilement à travers la deuxième couche et une partie de l'épaisseur de la première couche, selon un motif définissant les premières tranchées, formant des premières parties des premières tranchées, puis
- réalisation des portions diélectriques recouvrant les flancs latéraux des premières parties des premières tranchées, puis
- dépôt d'au moins un matériau électriquement conducteur dans les premières parties des premières tranchées, formant des premières parties des premières portions électriquement conductrices, puis
- solidarisation de l'empilement à un support tel que l'empilement soit disposé entre le substrat et le support, puis
- retrait du substrat, révélant une première face de la première couche, puis
- deuxième gravure de l'empilement à travers la première face de la première couche et selon un motif définissant les premières et les deuxième tranchées, avec arrêt sur les premières parties des premières portions électriquement conductrices, formant des deuxièmes parties des premières tranchées et la deuxième tranchée, puis
- dépôt du matériau électriquement conducteur dans les deuxièmes parties des premières tranchées et dans la deuxième tranchée, achevant la réalisation des premières portions électriquement conductrices et d'au moins une deuxième portion électriquement conductrice disposée dans la deuxième tranchée.

Ce deuxième mode de réalisation a pour avantage de permettre une réalisation de premières tranchées avec une plus faible largeur du fait que les premières tranchées sont réalisées avec deux étapes de gravure distinctes, de chaque côté de l'empilement, et permet donc d'augmenter la surface totale émissive et/ou de diminuer le pas de pixellisation de la matrice à surface émissive constante lorsque les diodes sont photo-émettrices.

Selon un troisième mode de réalisation, les premières tranchées, les portions diélectriques, les premières portions électriquement conductrices et la deuxième tranchée peuvent être réalisées en mettant en œuvre les étapes suivantes :
- après la réalisation des deuxièmes électrodes, solidarisation de l'empilement à un support tel que l'empilement soit disposé entre le substrat et le support, puis
- retrait du substrat, révélant une première face de la première couche, puis
- première gravure de l'empilement à travers les première et deuxième couches, selon un motif définissant les premières tranchées, formant les premières tranchées, puis
- réalisation des portions diélectriques recouvrant les flancs latéraux des premières parties des premières tranchées, puis
- dépôt d'au moins un matériau électriquement conducteur dans les premières tranchées, formant les premières portions électriquement conductrices, puis
- deuxième gravure de l'empilement à travers une partie de l'épaisseur de la première couche et selon un motif définissant la deuxième tranchée, formant la deuxième tranchée.

Après la deuxième gravure de l'empilement, il est possible de mettre en œuvre un dépôt d'au moins un matériau électriquement conducteur dans la deuxième tranchée, formant la deuxième portion électriquement conductrice.

Selon un quatrième mode de réalisation, les premières tranchées, les portions diélectriques, les premières portions électriquement conductrices et la deuxième tranchée peuvent être réalisées en mettant en œuvre les étapes suivantes :
- après la réalisation des deuxièmes électrodes, première gravure de l'empilement à travers la deuxième couche et la première partie de l'épaisseur de la première couche selon un motif définissant les premières tranchées, formant les premières tranchées, puis
- réalisation des portions diélectriques recouvrant les flancs latéraux des premières tranchées, puis
- dépôt d'au moins un matériau électriquement conducteur dans les premières tranchées, formant les premières portions électriquement conductrices qui recouvrent les parois de fond des premières tranchées, puis
- solidarisation de l'empilement à un support tel que l'empilement soit disposé entre le substrat et le support, puis
- retrait du substrat, révélant une première face de la première couche, puis
- deuxième gravure de l'empilement à travers la première face de la première couche et selon un motif définissant la deuxième tranchée, formant la deuxième tranchée.

Après la deuxième gravure de l'empilement, il est possible de mettre en œuvre un dépôt d'au moins un matériau électriquement conducteur dans la deuxième tranchée, formant la deuxième portion électriquement conductrice. Il est également possible de mettre en œuvre un amincissement de la première couche depuis la première face de la première couche.

Le support sur lequel l'empilement est solidarisé peut être par exemple un circuit électronique de contrôle, comportant par exemple des composants électroniques CMOS, sur lequel les diodes sont disposées et auquel les diodes sont reliées électriquement. Un tel circuit électronique peut notamment servir à commander électriquement les diodes lorsqu'elles correspondent à des diodes photo-émettrices. En variante, lorsque les diodes sont photo-réceptrices, ce circuit électronique peut servir à traiter les signaux délivrés par les diodes.

En variante, le support peut correspondre à un élément passif ne comportant pas de composants électroniques, comme par exemple un réseau d'interconnections, une carte ou un substrat organique.

La solidarisation de l'empilement sur le support comprend des connections électriques et la solidarisation se fait alors par exemple à l'aide d'un procédé d'hybridation, de collage direct ou de collage hybride.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent un premier exemple de réalisation d'un dispositif à diodes photo-émettrices et/ou photo-réceptrices, objet de la présente invention ;
- les figures 3 et 4 représentent d'autres exemples de réalisation du dispositif à diodes photo-émettrices et/ou photo-réceptrices, objet de la présente invention ;
- les figures 5 à 9 représentent les étapes d'un procédé de réalisation d'un dispositif à diodes photo-émettrices et/ou photo-réceptrices, objet de la présente invention, selon un premier mode de réalisation ;
- les figures 10 à 12 représentent différentes configurations de report de matrices de diodes sur un support commun mis en œuvre au cours d'un procédé de réalisation d'un dispositif à diodes photo-émettrices et/ou photo-réceptrices, objet de la présente invention ;
- les figures 13 à 15 représentent les étapes d'un procédé de réalisation d'un dispositif à diodes photo-émettrices et/ou photo-réceptrices, objet de la présente invention, selon un deuxième mode de réalisation ;
- la figure 16 représente un autre exemple de réalisation du dispositif à diodes photo-émettrices et/ou photo-réceptrices, objet de la présente invention ;
- les figures 17 à 22 représentent les étapes d'un procédé de réalisation d'un dispositif à diodes photo-émettrices et/ou photo-réceptrices, objet de la présente invention, selon un troisième mode de réalisation ;
- la figure 23 représente des simulations d'éclairement obtenues dans un pixel défini par des deuxièmes tranchées au sein d'un dispositif selon l'invention ;
- les figures 24 à 27 représentent les étapes d'un procédé de réalisation d'un dispositif à diodes photo-émettrices et/ou photo-réceptrices, objet de la présente invention, selon un quatrième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

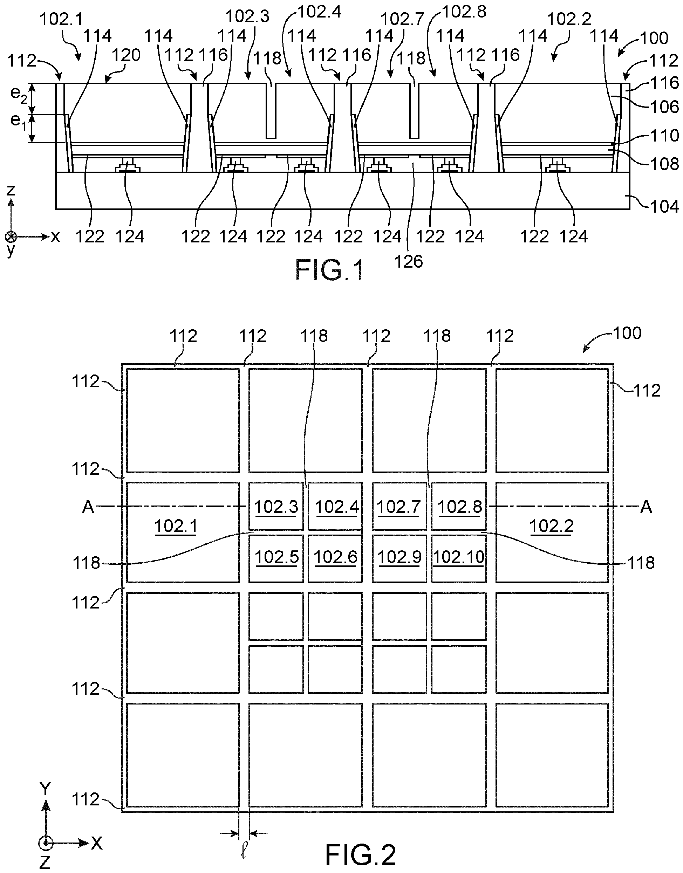

Un dispositif 100 à matrice de diodes 102 photo-émettrices et/ou photo-réceptrices, selon un premier exemple de réalisation, est décrit ci-dessous en lien avec les figures 1 et 2. La figure 1 représente une vue en coupe du dispositif 100 selon un axe AA visible sur la figure 2, et la figure 2 représente une vue de dessus du dispositif 100. Les figures 1 et 2 correspondent à des vues partielles ne représentant qu'une partie seulement du dispositif 100.

Le dispositif 100 comporte plusieurs diodes 102 disposées en matrice. Chaque diode 102 peut être considérée comme formant un pixel de la matrice du dispositif 100. En outre, dans ce premier exemple de réalisation, les diodes 102 correspondent à des diodes photo-émettrices, ici des LEDs ou des micro-LEDS.

Le dispositif 100 comporte un support 104 sur lequel les diodes 102 sont disposées. Dans le premier exemple de réalisation décrit ici, le support 104 correspond à un circuit électronique de contrôle, comportant par exemple des composants électroniques CMOS, sur lequel les diodes 102 sont disposées et auquel les diodes 102 sont reliées électriquement. Un tel circuit électronique peut notamment servir à commander électriquement les diodes 102 lorsqu'elles correspondent à des diodes photo-émettrices. En variante, lorsque les diodes 102 sont photo-réceptrices, ce circuit électronique peut servir à traiter les signaux délivrés par les diodes 102.

En variante, le support 104 peut correspondre à un élément passif ne comportant pas de composants électroniques, comme par exemple un réseau d'interconnexions, une carte ou un substrat organique.

Les diodes 102 sont réalisées dans un empilement d'au moins une première couche 106 de semi-conducteur disposée sur une deuxième couche 108 de semi-conducteur. En outre, dans ce premier exemple de réalisation, l'empilement comporte également une ou plusieurs couches émissives 110 disposées entre les première et deuxième couches 106, 108 et destinées à former chacune, dans les diodes 102, des puits quantiques.

Les première et deuxième couches 106, 108 et la ou les couches émissives 110 peuvent comporter un ou plusieurs semi-conducteurs de type III-V, et avantageusement du GaN et/ou de l'InGaN. Il est également possible que ce ou ces matériaux semi-conducteurs correspondent à un ou plusieurs des semi-conducteurs suivants : AIGaN, AlGaInN, InP, InGaP, AIGaP, AlGaInP, GaAs, InGaAs, AIGaAs.

Les semi-conducteurs des couches 106 et 108 sont dopés selon des types de conductivité différents. Dans le premier exemple de réalisation décrit ici, le semi-conducteur de la première couche 106 est dopé n et celui de la deuxième couche 108 est dopé p. En variante, il est possible que le semi-conducteur de la première couche 106 soit dopé p et que celui de la deuxième couche 108 soit dopé n.

Selon une première configuration, la première couche 106 peut correspondre à une superposition de plusieurs couches distinctes de semi-conducteur, par exemple une couche de semi-conducteur dopé n+ avec une concentration de donneurs par exemple comprise entre environ 5.10¹⁷ et 5.10²⁰ donneurs/cm³ sur laquelle est disposée une autre couche de semi-conducteur dopé n- (avec une concentration de donneurs inférieure à celle de la couche de semi-conducteur dopé n+) par exemple comprise entre environ 10¹⁷ et 5.10¹⁹ donneurs/cm³. Par exemple, la couche de semi-conducteur dopé n+ peut comporter du GaN et la couche de semi-conducteur dopé n-peut comporter de l'InGaN. L'épaisseur de la couche de semi-conducteur dopé n+ est par exemple supérieure à environ 100 nm, et par exemple égale à environ 3 µm, et celle de la couche de semi-conducteur dopé n- est par exemple comprise entre environ 5 nm et 500 nm. La couche de semi-conducteur dopé n+ peut former une couche tampon disposée entre la couche de semi-conducteur dopé n- et un substrat (non visible sur les figures 1 et 2, et qui correspond au substrat à partir duquel l'empilement de couches est réalisé) servant notamment à filtrer les défauts de croissance de la couche de semi-conducteur dopé n- afin que ces défauts ne se retrouvent pas dans cette couche dopé n+. L'épaisseur totale de la première couche 106, c'est-à-dire la somme des épaisseurs des couches de semi-conducteurs dopés n- et n+, est par exemple comprise entre environ 20 nm et 10 µm, et de préférence comprise entre environ 2 µm et 4 µm.

Selon une deuxième configuration, la première couche 106 peut correspondre à une seule couche de semi-conducteur dopé n, et avec une concentration de donneurs par exemple comprise entre environ 10¹⁷ et 5.10²⁰ donneurs/cm³, comportant par exemple du GaN et dont l'épaisseur est par exemple comprise entre environ 20 nm et 10 µm, et avantageusement comprise entre environ 2 µm et 4 µm.

La ou les couches émissives 110 comportent des matériaux semi-conducteurs dits intrinsèques, c'est-à-dire non intentionnellement dopés (de concentration en donneurs résiduels n_{nid} par exemple égale à environ 10¹⁷ donneurs/cm³, ou comprise entre environ 10¹⁵ et 10¹⁸ donneurs/cm³). La ou les couches émissives 110 comportent par exemple de l'InGaN. La couche émissive 110 ou chacune des couches émissives 110 est disposée entre deux couches barrières (non visibles sur les figures), comprenant par exemple du GaN. La ou les couches émissives 110 sont disposées sur la première couche 106. L'épaisseur de la ou de chacune des couches émissives 110 est par exemple égale à environ 3 nm et plus généralement comprise entre environ 0,5 nm et 10 nm, et l'épaisseur de chacune des couches barrières est par exemple comprise entre environ 1 nm et 25 nm.

La deuxième couche 108 est disposée sur la ou les couches émissives 110, ou directement sur la première couche 106 lorsque l'empilement ne comporte pas de couche émissive 110. Le semi-conducteur de la deuxième couche 108 est par exemple du GaN et son épaisseur est par exemple comprise entre environ 20 nm et 10 µm. La deuxième couche 108 a par exemple une concentration d'accepteurs comprise entre environ 10¹⁷ et 5.10¹⁹ accepteurs/cm³.

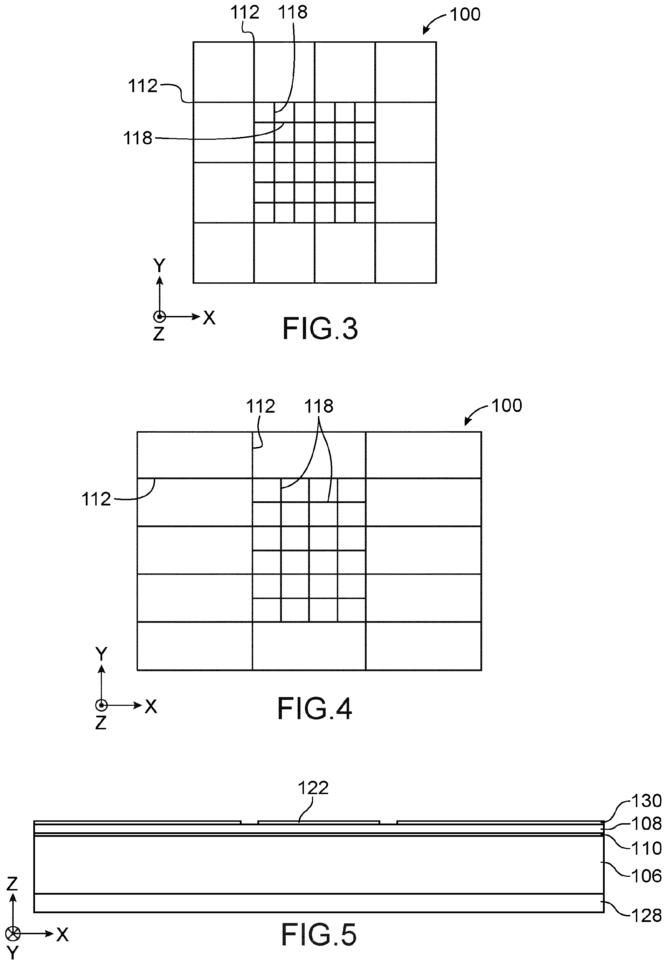

Dans une variante de réalisation, une couche de blocage d'électrons (non visible sur les figures 5 à 9) peut être disposée entre la deuxième couche 108 et la ou les couches émissives 110, cette couche de blocage d'électrons comprenant par exemple de l'AIGaN avec par exemple environ 12% d'aluminium et dopée p avec une concentration d'accepteurs par exemple égale à environ 1.10¹⁷ accepteurs/cm³.

Des matériaux autres que ceux cités ci-dessus peuvent être utilisés pour réaliser l'empilement de couches décrit ci-dessus.

Des portions superposées des couches 106, 108, 110 de cet empilement forment des jonctions p-n (ou plus exactement p-i-n dans ce premier mode de réalisation, en raison de la présence de la ou des couches 110 qui ne sont pas dopées intentionnellement et qui sont disposées entre les couches 106, 108) des diodes 102.

Le dispositif 100 comporte également des premières tranchées 112 qui, dans ce premier exemple de réalisation, traversent toute l'épaisseur de l'empilement de couches 106, 108, 110. Ces premières tranchées 112 sont par exemple réalisées en formant un quadrillage. Ces premières tranchées 112 délimitent plusieurs régions de l'empilement (et plus généralement au moins une région de l'empilement) formant les jonctions p-n des diodes 102. La distance entre deux premières tranchées 112 voisines et parallèles l'une de l'autre est par exemple égale à environ 90 µm. Dans l'exemple de réalisation décrit ici, les diodes 102 seront réalisées sous la forme de structures mesa, ou structures en îlots, délimitées par les premières tranchées 112. Les régions de l'empilement entourées par les premières tranchées 112 ont par exemple une section, dans un plan parallèle à la face du support 104 sur laquelle se trouve l'empilement, par exemple en forme de disque ou de rectangle ou plus généralement de polygone (forme carrée sur l'exemple des figures 1 et 2).

Dans le premier exemple de réalisation décrit ici, les premières tranchées 112 sont régulièrement espacées les unes des autres et délimitent des régions de l'empilement de dimensions sensiblement similaires les unes des autres.

Des portions diélectriques 114 sont disposées dans chacune des premières tranchées 112 et recouvrent des flancs latéraux des régions de l'empilement entourées par les premières tranchées 112. Les portions diélectriques 114 recouvrent ces flancs latéraux sur toute l'épaisseur de la deuxième couche 108 et de la ou des couches 110, ainsi que sur une première partie de l'épaisseur de la première couche 106. Sur la figure 1, cette première partie de l'épaisseur de la première couche 106 est appelée e₁. Selon l'épaisseur totale de la première couche 106, la première partie de l'épaisseur de la première couche 106 e₁ est par exemple comprise entre environ 100 nm et 5 µm. Les portions diélectriques 114 comportent par exemple du SiO₂ et/ou du SiN.

Des premières portions électriquement conductrices 116 sont disposées dans chacune des premières tranchées 112. Ces premières portions 116 recouvrent les flancs latéraux des régions de l'empilement entourées par les premières tranchées 112. Les premières portions 116 recouvrent ces flancs latéraux sur une deuxième partie de l'épaisseur de la première couche 106. Sur la figure 1, cette deuxième partie de l'épaisseur de la première couche 106 est appelée e₂. Ainsi, les premières portions 116 sont reliées électriquement au matériau semi-conducteur dopé n de la première couche 106. De plus, grâce à la présence des portions diélectriques 114 dans chacune des premières tranchées 112, les premières portions électriquement conductrices 116 sont isolées électriquement de la deuxième couche 108 et de la ou des couches 110. Dans le but d'optimiser la qualité du contact électrique entre les premières portions électriquement conductrices 116 et la première couche 106, on cherchera à maximiser le rapport e2/e1.

Le dispositif 100 comporte également des deuxièmes tranchées 118 (et plus généralement au moins une deuxième tranchée 118) traversant partiellement l'épaisseur de la première couche 106 depuis une face 120 de la première couche 106 opposée à celle se trouvant en regard, ou du côté, de la deuxième couche 108. Cette face 120 correspond à la face émissive des diodes 102. Ces deuxièmes tranchées 118 séparent, au sein d'une ou plusieurs régions de l'empilement entourées par les premières tranchées 112, plusieurs portions de la première couche 106 afin de séparer optiquement, au sein de la ou de chacune de ces régions de l'empilement, plusieurs diodes 102. L'épaisseur de la première couche 106 qui n'est pas traversée par les deuxièmes tranchées 118 est par exemple comprise entre 20 nm et 500 nm, ou entre 100 nm et 500 nm. Il est possible que l'épaisseur de la première couche 106 qui n'est pas traversée par les deuxièmes tranchées 118 soit égale à e₁.

La largeur de chacune des premières et deuxièmes tranchées 112, 118 (dimension selon l'axe X sur la figure 1) est par exemple comprise entre environ 0,5 µm et 5 µm. Les largeurs des premières tranchées 112 peuvent être similaires ou différentes de celles des deuxièmes tranchées 118.

Selon une variante de réalisation (qui ne correspond pas à celle visible sur les figures 1 et 2), les deuxièmes tranchées 118 peuvent être remplies au moins partiellement par un ou plusieurs matériaux optiquement réflecteurs, par exemple un ou plusieurs matériaux métalliques, formant des deuxièmes portions électriquement conductrices. Les deuxièmes portions électriquement conductrices permettent d'améliorer l'isolation optique entre les pixels réalisés dans une même région de l'empilement entourée par des premières tranchées 112.

Le matériau des premières portions électriquement conductrices 116, et éventuellement celui des deuxièmes portions électriquement conductrices lorsque de telles deuxièmes portions sont présentes dans les deuxièmes tranchées 118, correspondent par exemple à l'un des matériaux suivants : Al, Ag, Au, Cu.

Lorsqu'aucun matériau électriquement conducteur n'est disposé dans les deuxièmes tranchées 118, les premières portions électriquement conductrices 116 forment des premières électrodes des diodes 102 reliées électriquement au semi-conducteur dopé n des diodes 102. Dans le premier exemple de réalisation décrit ici, les premières électrodes de toutes les diodes 102 de la matrice du dispositif 100 sont formées par les premières portions 116 et sont reliées électriquement entre elles, par exemple au niveau d'un bord de la matrice, et forment une première électrode (ici une cathode) commune à toutes ces diodes 102. Dans ce premier exemple de réalisation, bien que cela ne soit pas visible sur les figures 1 et 2, les premières électrodes sont reliées électriquement au circuit de contrôle formant le support 104.

Lorsque des deuxièmes portions électriquement conductrices sont disposées dans les deuxièmes tranchées 118, les premières électrodes des diodes 102 réalisées dans les régions de l'empilement traversées par les deuxièmes tranchées 118 sont formées par les premières portions électriquement conductrices 116 et par les deuxièmes portions électriquement conductrices.

Lorsque les deuxièmes tranchées 118 croisent les premières tranchées 112, comme c'est le cas sur l'exemple de réalisation des figures 1 et 2, le caractère électriquement conducteur des deuxièmes portions électriquement conductrices permet d'assurer un contact électrique avec les premières électrodes.

Sur l'exemple représenté sur les figures 1 et 2, chacune des diodes 102.1 et 102.2 est formée par une région de l'empilement entourée par des premières tranchées 112 et ces régions ne sont pas traversées par des deuxièmes tranchées 118. Par contre, les quatre diodes 102.3, 102.4, 102.5 et 102.6 sont formées dans une seule région de l'empilement entourée par des premières tranchées 112 et qui est traversée par des deuxièmes tranchées 118 séparant en quatre portions la partie de la première couche 106 de cette région de l'empilement, chacune de ces quatre portions faisant partie d'une des quatre diodes 102.3, 102.4, 102.5 et 102.6. Il en est de même pour les quatre diodes 102.7, 102.8, 102.9 et 102.10.

Chacune des diodes 102 comporte également une deuxième électrode couplée électriquement à la portion de la deuxième couche 108 formant la jonction p-n de cette diode 102. Dans le premier exemple de réalisation décrit ici, chaque deuxième électrode est formée par une portion électriquement conductrice 122 disposée contre la portion de la deuxième couche 108 et par un élément de liaison électrique 124 reliant la portion électriquement conductrice 122 au circuit électronique de contrôle formant le support 104. Le matériau électriquement conducteur des portions 122 est par exemple optiquement réflecteur, et correspond par exemple à de l'aluminium ou de l'argent.

Pour les diodes 102 formées dans une région de l'empilement qui est traversée par une ou plusieurs deuxièmes tranchées 118, les portions électriquement conductrices 122 des deuxièmes électrodes de ces diodes sont isolées électriquement les unes des autres. Le motif gravé dans la couche électriquement conductrice (à partir de laquelle les portions 122 sont réalisées) pour isoler ces portions 122 les unes des autres peut être similaire à celui de la ou des deuxièmes tranchées 118 traversant la région de l'empilement.

Chacune des deuxièmes électrodes 122 est reliée électriquement au circuit de contrôle formant le support 104 de manière individuelle afin de pouvoir piloter individuellement chacune des diodes 102. Un matériau diélectrique 126 est présent autour des éléments de liaison électrique 124 pour assurer leur isolation électrique les uns des autres ainsi que leur protection mécanique vis-à-vis de l'environnement.

Dans la matrice de diodes 102 du dispositif 100 représenté sur les figures 1 et 2, la densité de diodes 102 au sein de cette matrice n'est pas uniforme. Dans ce premier exemple, cette densité est quadruplée au centre de la matrice, au niveau de quatre régions de l'empilement entourées chacune par des premières tranchées 112. Le pas de pixellisation de la matrice de diodes 102, c'est-à-dire la distance entre les centres de deux diodes 102 voisines, obtenu dans les régions qui comportent les deuxièmes tranchées 118 est par exemple égale à 45 µm, tandis que ce pas de pixellisation dans les régions ne comportant pas les deuxièmes tranchées est par exemple égal à 90 µm. Plus généralement, le pas de pixellisation des diodes 102 défini par les premières tranchées 112 est typiquement compris entre environ 1 µm et 500 µm.

La figure 3 représente, schématiquement et vue de dessus, un autre exemple de réalisation du dispositif 100 dans lequel quatre régions de l'empilement de couches sont divisées chacune en neuf sous-régions formant chacune une diode 102. Chacune de ces régions de l'empilement est entourée par des premières tranchées 112. Il convient de noter que dans cette configuration, dans chacune des quatre régions centrales, la sous-région se trouvant au centre ne comporte pas de flanc latéral formé par une des premières tranchées 112. Ainsi, lorsque les deuxièmes tranchées 118 ne sont pas remplies par un matériau électriquement conducteur, cette sous-région centrale ne forme pas une diode puisque la portion de semi-conducteur de la première couche 106 de cette sous-région n'est pas reliée électriquement à une première électrode formée dans les premières tranchées 112. Par contre, lorsque les deuxièmes tranchées 118 sont remplies par des deuxièmes portions électriquement conductrices, du fait que les deuxièmes tranchées 118 croisent les premières tranchées 112, les deuxièmes portions électriquement conductrices sont en contact électriquement avec les premières portions électriquement conductrices 116 des premières électrodes. Tous les flancs latéraux des différentes sous-régions sont donc en contact électriquement avec un élément (premières portions électriquement conductrices 116 ou deuxièmes portions électriquement conductrices) formant une première électrode pour chacune des diodes 102 de ces sous-régions.

La figure 4 représente un autre exemple de réalisation du dispositif 100 dans lequel trois régions de l'empilement de couches sont divisées chacune en huit sous-régions formant chacune une diode 102. Chacune de ces régions de l'empilement est entourée par des premières tranchées 112. Dans cette configuration, toutes les jonctions p-n formées dans chacune de ces trois régions comportent au moins un flanc latéral en contact électriquement avec une des premières tranchées 112. Toutes les parties de chacune de ces régions forment des diodes 102 fonctionnelles, que les deuxièmes tranchées 118 soient remplies ou non par un matériau électriquement conducteur.

De manière générale, le nombre de diodes distinctes séparées par les deuxièmes tranchées 118 au sein d'une région de l'empilement entourée par des premières tranchées 112 est supérieur ou égal à 2 et peut atteindre plusieurs milliers voire plusieurs millions ou plus en fonction de la résolution finale du dispositif.

Dans les exemples décrits ci-dessus, la densité de diodes 102 est plus importante au centre de la matrice de diodes 102 que sur les bords de la matrice. En variante, il est possible que cette plus forte densité de diodes soit localisée à un ou plusieurs endroits dans la matrice autres que le centre.

Un procédé de réalisation du dispositif 100 selon un premier mode de réalisation est décrit ci-dessous en lien avec les figures 5 à 9.

Dans ce premier mode de réalisation, le dispositif 100 comporte une matrice de diodes 102 formant une matrice de pixels du dispositif 100. En outre, dans le premier mode de réalisation décrit ci-dessous, les diodes 102 correspondent à des diodes photo-émettrices, ici des LEDs.

Comme représenté sur la figure 5, le dispositif 100 est réalisé à partir d'un substrat 128 comprenant par exemple du saphir et/ou du silicium et/ou un semi-conducteur par exemple similaire à celui utilisé pour former la partie active des diodes 102, et/ou du siliciure de carbone et/ou du verre et/ou tout autre matériau permettant au substrat 128 de former un substrat de croissance permettant la réalisation de l'empilement semi-conducteur formant la partie active des diodes 102 par épitaxie. Le substrat 128 sert de support pour le dépôt et/ou la croissance de couches destinées à la réalisation des diodes 102 du dispositif 100.

L'empilement de couches à partir duquel les diodes 102 vont être réalisées est formé sur le substrat 128. Cet empilement comporte la première couche de semi-conducteur 106, la ou les couches émissives 110, la deuxième couche de semi-conducteur 108 et une couche électriquement conductrice 130 formant, dans chacune des diodes 102, les portions 122 des deuxièmes électrodes (correspondant à l'anode dans l'exemple décrit ici) qui seront en contact avec le semi-conducteur de la deuxième couche 108. La couche électriquement conductrice 130 est disposée sur la deuxième couche 108.

Une première étape formant la couche électriquement conductrice 130 est mise en œuvre afin de réaliser les portions 122 des deuxièmes électrodes des diodes 102. Cette couche 130 est par exemple déposée sur la couche 108 puis retirée localement par un procédé dit « lift-off » afin de former les portions 122 qui seront, au sein d'une même région de l'empilement, entourées par des premières tranchées 112 et comprenant une ou plusieurs deuxièmes tranchées 118, isolées électriquement les unes des autres. La structure obtenue à ce stade du procédé est représentée sur la figure 5. Les zones retirées de la couche électriquement conductrice 130 sont disposées sensiblement en regard des régions où les deuxièmes tranchées 118 seront réalisées par la suite.

Une couche destinée à former un masque dur diélectrique est ensuite disposée sur la couche électriquement conductrice 130. Le matériau de cette couche est par exemple du SiO₂ ou SIN. Cette couche est gravée pour former un masque dur diélectrique 132 qui servira notamment de masque pour la gravure des autres couches de l'empilement. Le motif de ce masque dur 132 correspond à celui des premières tranchées 112.

Une gravure à travers les couches 130, 108, 110 et une première partie de l'épaisseur de la première couche 106 est ensuite mise en œuvre selon le motif du masque dur diélectrique 132. Cette gravure correspond par exemple à une gravure sèche, par exemple par un plasma à base de Cl₂ ou une gravure RIE, par exemple ICP-RIE (gravure ionique réactive par un système de torche à plasma, ou « Inductively Coupled Plasma - Reactive Ion Etching »).

Cette gravure est stoppée à un niveau de profondeur situé dans la première couche 106 et telle que des parois de fond des tranchées gravées soient formées par la première couche 106. L'épaisseur de la première couche 106 gravée lors de cette gravure est égale à l'épaisseur e₁. Cette gravure est réalisée telle que l'épaisseur restante de la première couche 106, c'est-à-dire la deuxième partie de l'épaisseur de la première couche 106 e₂, soit suffisante pour réaliser un bon contact électrique entre le ou les semi-conducteurs de la première couche 106 et les premières portions électriquement conductrices 116 qui seront réalisées ultérieurement dans les premières tranchées 112. Cette gravure forme une première partie des premières tranchées 112.

Une couche diélectrique, correspondant par exemple à un bicouche SiN/Si0₂ ou comportant de l'Al₂O₃, et formant une couche de passivation, est ensuite déposée avec une épaisseur conforme, par exemple comprise entre environ 5 nm et 1 µm et avantageusement égale à environ 200 nm, sur le masque dur 132 et le long des parois des premières parties des premières tranchées 112, recouvrant donc les parois latérales formées du masque dur 132 et des régions de l'empilement des couches 106, 108, 110, 130 qui sont entourées par les première parties des premières tranchées 112 gravées. La couche diélectrique est également déposée sur les parties non gravées de la première couche 106 formant les parois de fond de ces premières parties des premières tranchées 112. Cette couche diélectrique est par exemple formée par un dépôt de type PECVD (dépôt chimique en phase vapeur assisté par plasma) ou ALD (dépôt de couche atomique) selon la nature du ou des matériaux déposés.

Une gravure anisotrope, par exemple une gravure sèche telle qu'une gravure RIE, est ensuite mise en œuvre telle que les parties de la couche diélectrique se trouvant dans les premières parties des premières tranchées 112 et ne recouvrant pas les parois latérales des premières parties des premières tranchées 112 soient supprimées, révélant ainsi les parties de la première couche 106 se trouvant au fond des premières parties des premières tranchées 112. Les parties de cette couche diélectrique recouvrant la face supérieure du masque dur 132 sont également supprimées. Ainsi, seules les portions 114 de la couche diélectrique recouvrant les parois latérales des premières parties des premières tranchées 112 sont conservées.

Une deuxième gravure de l'empilement est mise en œuvre, prolongeant les premières tranchées 112 à travers l'épaisseur restante e₂ de la première couche 106 de semi-conducteur jusqu'à atteindre le substrat 128, c'est-à-dire jusqu'à ce que les parois de fond des premières tranchées 112 soient formées par le substrat 128. Cette deuxième gravure permet de révéler des parties des flancs latéraux de la première couche 106 sur la deuxième partie de l'épaisseur de la première couche 106 qui vont former des zones de contact électrique pour les premières portions électriquement conductrices 116.

Des ouvertures sont ensuite réalisées à travers le masque diélectrique 132, formant des emplacements pour la réalisation des éléments de liaison électrique 124 destinés à assurer les contacts électriques avec les deuxièmes électrodes. Ces ouvertures traversent toute l'épaisseur du masque diélectrique 132 afin que les parois de fond de ces ouvertures soient formées par les portions électriquement conductrices 122. Cette gravure est par exemple de type ICP-RIE.

Un ou plusieurs matériaux électriquement conducteurs sont ensuite déposés dans les premières tranchées 112 et dans les emplacements des liaisons électriques 124, formant les premières portions électriquement conductrices 116 et les éléments de liaison électrique 124.

Selon un exemple de réalisation, un premier matériau électriquement conducteur peut être déposé dans les premières tranchées 112 et dans les emplacements des éléments de liaison électrique 124 ainsi que sur le masque diélectrique 132. Ce premier matériau électriquement conducteur est déposé de manière conforme, c'est-à-dire en formant une couche d'épaisseur sensiblement constante sur le masque diélectrique 132 et le long des parois latérales et les parois de fond des premières tranchées 112 et des emplacements des éléments de liaison électrique 124. Par exemple, ce premier matériau électriquement conducteur peut être formé par le dépôt, par exemple de type PVD, d'une première couche de titane d'épaisseur par exemple inférieure à environ 300 nm, suivi d'un dépôt, par exemple PVD, d'une deuxième couche d'aluminium d'épaisseur par exemple comprise entre environ 50 nm et 1 µm. Les techniques de dépôts mises en œuvre sont choisies pour qu'elles soient adaptées au facteur de forme important des volumes formés par les premières tranchées 112, et correspondent par exemple à celles mises en œuvre pour déposer le ou les matériaux électriquement conducteurs des vias conducteurs ou TSV (« Through-Silicon Via »). Ensuite, un deuxième matériau électriquement conducteur peut être déposé en remplissant les volumes restants des premières tranchées 112 et des emplacements des éléments de liaison électrique 124. L'épaisseur de ce deuxième matériau électriquement conducteur peut être telle qu'il recouvre également les parties du premier matériau électriquement conducteur disposées sur le masque diélectrique 132. Ce deuxième matériau électriquement conducteur est par exemple du cuivre qui peut être formé par la mise en œuvre d'un dépôt électrochimique (ECD ou « Electro-Chemical Deposition ») pleine plaque, c'est-à-dire sur l'ensemble de la structure précédemment réalisée. Une planarisation mécano-chimique (CMP) peut ensuite être mise en œuvre afin de supprimer les portions des premier et deuxième matériaux électriquement conducteurs qui dépassent des premières tranchées 112 et des emplacements des éléments de liaison électrique 124. Cette planarisation permet d'achever la réalisation des portions électriquement conductrices 116 et des liaisons électriques 124 et d'isoler électriquement ces portions électriquement conductrices 116 vis-à-vis des liaisons électriques 124.

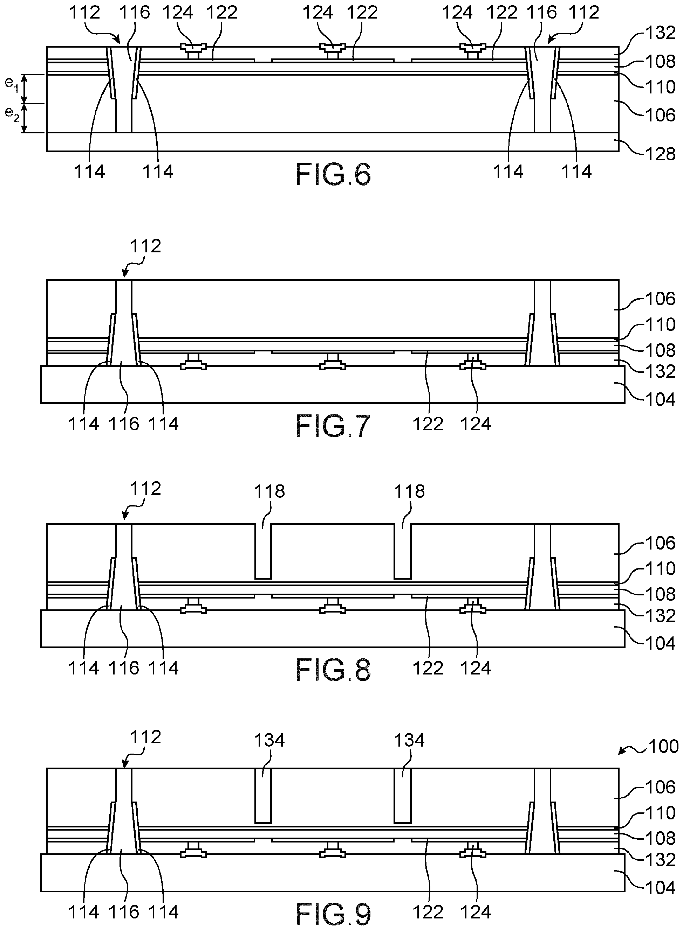

La structure obtenue à ce stade du procédé correspond à celle visible sur la figure 6.

Il convient de noter que sur les figures 5 à 9, une seule région de l'empilement entourée par des premières tranchées 112 est représentée. Toutefois, le dispositif 100 comporte d'autres régions de l'empilement également entourées par des premières tranchées 112 et qui ne sont pas visibles sur ces figures.

Grâce aux portions diélectriques 114 verticales, les premières portions électriquement conductrices 116 sont bien isolées électriquement des couches 108 et 110. L'épaisseur des portions diélectriques 114 peut être choisie telle qu'un courant de fuite acceptable soit toléré sur chacune des diodes 102, par exemple inférieur à environ 1 % du courant nominal traversant la diode 102, lorsqu'elles sont soumises à une différence de potentiels (appliquée entre la cathode et l'anode) par exemple de l'ordre de 4 Volts. L'épaisseur minimale des portions diélectriques 114 est par exemple comprise entre environ 3 nm et 5 nm, ou entre 3 nm et 4 nm, en fonction du ou des matériaux utilisés pour réaliser les portions diélectriques 114.

La structure réalisée est ensuite hybridée sur le support 104. Par exemple, cette hybridation peut correspondre à un collage direct (« direct bonding », également appelé collage par adhésion moléculaire), ou un collage hybride cuivre - oxyde et thermocompression Au/Au, ou faire appel à des éléments de connexion électrique entre la matrice de diodes 102 (et plus précisément les éléments de liaison électrique 124) et le circuit électronique comme par exemple des billes en alliage fusible (comprenant par exemple du SnAg et/ou de l'indium), ou à des piliers de cuivre recouverts d'un matériau de soudure, ou à des micro-inserts, ou à des micro-tubes. Des détails de mise en œuvre d'un collage direct sont par exemple décrits dans le document « Mechanisms of copper direct bonding observed by in-situ and quantitative transmission electron microscopy » de M. Martinez et al., Thin Solid Films 530 (2013) 96-99.

Après ce report, le substrat 128 est supprimé, libérant ainsi des faces arrière des diodes par lesquelles la lumière est destinée à entrer ou sortir suivant que les diodes 102 soient des diodes photo-émettrices ou photo-réceptrices (voir figure 7). Le substrat 128 est par exemple retiré par décollement laser (« laser lift-off » en anglais) lorsque le substrat 128 comporte du saphir, ou par meulage (« grinding » en anglais) et attaque chimique sélective lorsque le substrat 128 comporte par exemple un semi-conducteur tel que du silicium.

Les deuxièmes tranchées 118 sont ensuite réalisées à travers une partie de l'épaisseur de la première couche 106, telle que les parois de fond de ces deuxièmes tranchées 118 soient formées par le matériau de la première couche 106 (voir figure 8). Les deuxièmes tranchées 118 sont par exemple réalisées en mettant en œuvre une gravure effectuée en utilisant un masque dur par exemple de SiO₂. Ces deuxièmes tranchées 118 marquent la séparation physique et optique entre les diodes 102 réalisées dans la région de l'empilement entourée par les premières tranchées 112. Lorsque les deuxièmes tranchées 118 sont destinées à être remplies d'au moins un matériau électriquement conducteur assurant une fonction de contact électrique avec le semi-conducteur de la première couche 106, les deuxièmes tranchées 118 présentent au moins une région de recouvrement avec les premières tranchées 112 pour assurer une continuité du contact électrique avec le semi-conducteur de la première couche 106.

La réalisation du dispositif 100 est achevée par le remplissage des deuxièmes tranchées 118 par au moins un matériau électriquement conducteur formant des deuxièmes portions électriquement conductrices 134 (voir figure 9). Ce remplissage peut être obtenu en mettant en œuvre des étapes similaires à celles mise en œuvre pour réaliser les premières portions électriquement conductrices 116. Le masque dur servant lors de la gravure et du remplissage des deuxièmes tranchées 118 peut être conservé s'il est transparent au rayonnement, ou supprimé, voire structuré (par exemple par des cristaux photoniques) pour améliorer l'extraction lumineuse ou la directivité d'émission.

En fin du procédé, il est possible de déposer un matériau électriquement conducteur transparent, par exemple de l'ITO (oxyde d'indium et d'étain) ou de l'AZO (oxyde de zinc et d'aluminium) ou du GZO (oxyde de zinc et de gallium), sur la face supérieure de l'ensemble réalisé afin d'améliorer le contact électrique entre le semi-conducteur de la première couche 106 et les premières et deuxièmes portions électriquement conductrices 116, 134. Dans ce cas, le retrait du masque dur est nécessaire.

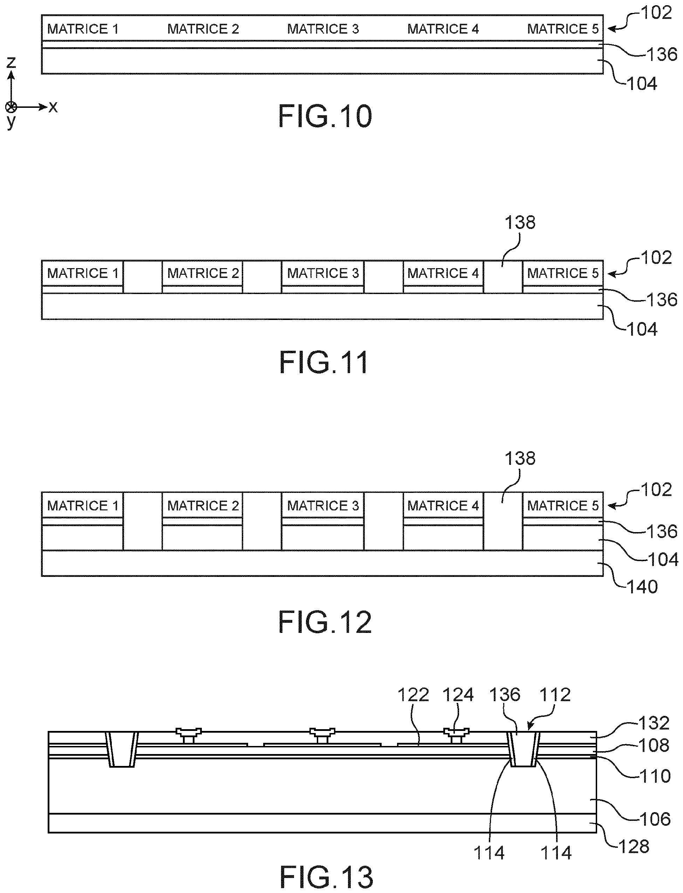

Dans le procédé décrit ci-dessus, le report des diodes 102 sur le support 104 correspond à une solidarisation substrat à substrat, ou « wafer-to-wafer », c'est-à-dire que plusieurs matrices de diodes 102 sont réalisées simultanément dans les couches 106, 108, 110 et que ces matrices sont reportées ensemble sur un substrat formant le support 104. Cette configuration est schématisée sur la figure 10, sur laquelle la référence 136 désigne l'interface de solidarisation (collage, éléments d'interconnexions, etc.) entre les matrices de diodes 102 et le substrat formant le support 104.

Selon une variante, il est possible que les matrices de diodes 102 réalisées simultanément dans les couches 106, 108, 110 soient tout d'abord découpées sous la forme de puces individuelles, puis reportées individuellement sur le substrat formant le support 104. Cette variante correspond à une solidarisation de type puces à substrat, ou "chip-to-wafer", mise en œuvre avec les techniques d'hybridation précédemment mentionnées. Dans ce cas, avant la mise en œuvre des étapes formant les deuxièmes tranchées 118, les espaces entre les matrices de diodes 102 sont remplis par un matériau 138, par exemple un diélectrique. Cette configuration est schématisée sur la figure 11.

Selon encore une autre variante, il est possible que les matrices de diodes 102 réalisées simultanément dans les couches 106, 108, 110 soient tout d'abord découpées sous la forme de puces individuelles, puis reportées individuellement sur le substrat formant le support 104 également préalablement découpé sous la forme de puces individuelles. Cette autre variante correspond à une solidarisation de type puces à puces, ou "chip-to-chip". Chaque ensemble formé d'une matrice de diodes 102 et d'un circuit de contrôle est ensuite reporté sur un autre support 140 et les espaces entre les ensembles "puces de matrices de diodes 102 reportées sur puces de substrats support 104" sont remplis par un matériau 138, par exemple un diélectrique. Cette configuration est schématisée sur la figure 12.

Dans tous les cas, à l'issue de la réalisation des dispositifs 100, une étape de découpe est mise en œuvre pour séparer les dispositifs 100 les uns des autres.

Dans le premier mode de réalisation décrit ci-dessus, les premières tranchées 112 sont réalisées en gravant toute l'épaisseur de l'empilement formé par les couches 106, 108 et 110. En variante, il est possible que la deuxième gravure de l'empilement mise en œuvre après avoir réalisé les portions diélectriques 114 ne soit réalisée non pas à travers toute l'épaisseur restante de la première couche 106, mais à travers une partie seulement de cette épaisseur restante. Dans ce cas, les premières portions électriquement conductrices 116 réalisées dans les premières tranchées 112 sont en contact électriquement avec le matériau de la première couche 106 au niveau des parties des parois latérales des premières tranchées 112 qui ne sont pas recouvertes par les portions diélectriques 114 et au niveau des parois de fond des premières tranchées 112. Ensuite, de manière optionnelle, après avoir reporté l'empilement sur le support 104 et supprimé le substrat 128, il est possible de mettre en œuvre un amincissement de la première couche 106 depuis la face contre laquelle se trouvait auparavant le substrat 128, jusqu'à atteindre les premières portions électriquement conductrices 116. Cet amincissement permet de diminuer la diaphonie optique entre les pixels et permet de diminuer la largeur des premières tranchées 112 en conservant un rapport de forme constant (contrainte de lithographie et de gravure profonde).

On décrit ci-dessous, en lien avec les figures 13 à 15, un procédé de réalisation du dispositif 100 selon un deuxième mode de réalisation.

Dans le premier mode de réalisation décrit précédemment en lien avec les figures 5 à 9, les premières tranchées 112 sont gravées, avant le report sur le support 104, à travers les couches 130, 106, 108 et 110 avec une profondeur égale à la hauteur souhaitée pour les premières portions électriquement conductrices 116. Dans le deuxième mode de réalisation décrit ici, les premières tranchées 112 sont gravées, avant le report sur le support 104, partiellement à travers toute l'épaisseur de la couche 130, de la deuxième couche 108 (et de la ou des couches émissives 110 si de telles couches sont présentes dans l'empilement) et à travers une partie seulement (épaisseur e₁) de l'épaisseur de la première couche 106.

Les portions diélectriques 114 et des portions électriquement conductrices 136, formant des premières parties des portions 116, sont réalisées ensuite dans ces parties des premières tranchées 112 qui ne traversent pas toute l'épaisseur de la première couche 106 (voir figure 13).

L'ensemble est ensuite reporté sur le support 104, comme dans le premier mode de réalisation.

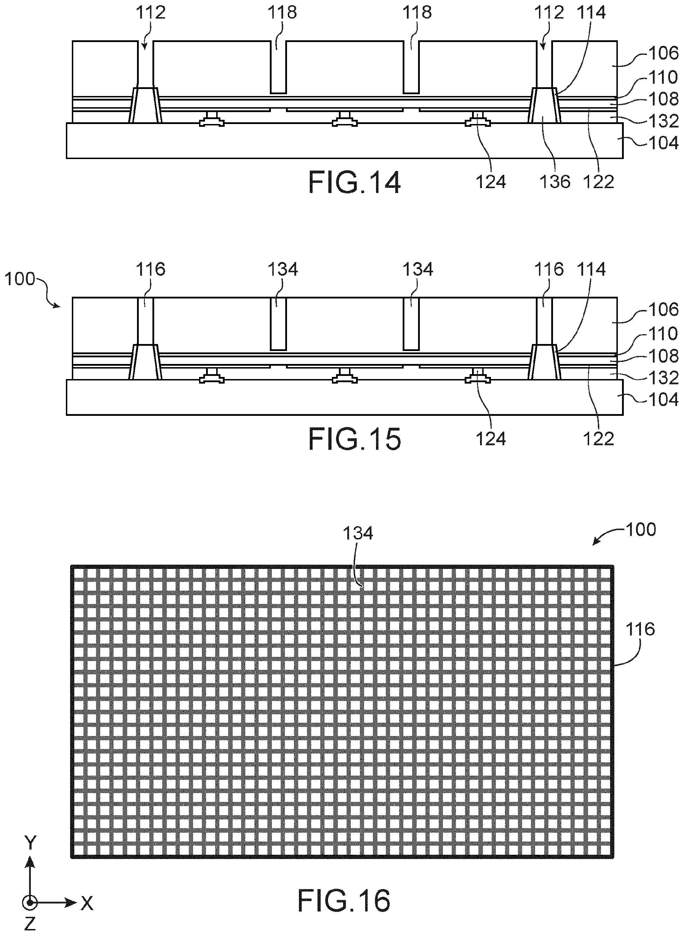

Une gravure est ensuite mise en œuvre pour terminer de graver les premières tranchées 112 et en même temps graver les deuxièmes tranchées 118 (voir figure 14).

Les premières tranchées 112 et les deuxièmes tranchées 118 sont ensuite remplies d'un ou plusieurs matériaux électriquement conducteurs, achevant ainsi la réalisation des premières portions électriquement conductrices 116 et formant les deuxièmes portions électriquement conductrices 134 (voir figure 15).

Dans ce deuxième mode de réalisation, les premières portions électriquement conductrices 116 sont donc réalisées en deux temps. Cela est avantageux car l'épaisseur restante (épaisseur e₂) de la première couche 106 qui n'est pas gravée lors de la réalisation de la première partie des portions 116 (étape visible sur la figure 13) correspond à la profondeur des deuxièmes tranchées 118. Les premières parties 136 des portions 116 forment alors un matériau d'arrêt de gravure lors de la réalisation des deuxièmes tranchées 118 et de l'achèvement des premières tranchées 112.

Dans ce deuxième procédé de réalisation, il est également possible de réaliser un amincissement de la première couche 106 après le retrait du substrat 128 et avant la gravure des deuxièmes tranchées 118. Un tel amincissement est judicieux lorsque la première couche 106 comporte une partie non-dopée disposée du côté du substrat 128, cet amincissement pouvant supprimer cette partie non dopée.

Ce deuxième mode de réalisation permet également de relâcher les contraintes sur la largeur des premières tranchées 112. En effet, étant donné que la gravure de ces tranchées passe par la mise en œuvre de deux étapes distinctes, des deux côtés de l'empilement, la profondeur de matériau à graver à chacune de ces deux étapes est donc moindre que lorsque les premières tranchées 112 sont réalisées avec la mise en œuvre d'une seule étape de gravure, ce qui permet de réduire le rapport de forme (« aspect ratio » en anglais, c'est-à-dire le rapport entre la valeur de la profondeur d'une tranchée et la valeur de la largeur de la tranchée) des tranchées. Cet amincissement permet donc au final l'obtention de premières tranchées 112 moins large que lorsqu'elles sont réalisées avec la mise en œuvre d'une seule étape de gravure à travers toute l'épaisseur des couches 130, 106, 108 et 110.

Dans les exemples de réalisation précédemment décrits, la matrice de pixels réalisée comporte plusieurs régions de l'empilement chacune entourée par des premières tranchées, et des deuxièmes tranchées sont réalisées dans au moins une partie de ces régions. Selon un autre exemple de réalisation, il est possible que la matrice de pixels du dispositif 100 comporte une seule région de l'empilement entourée par des premières tranchées 112, et que cette région soit traversée par des deuxièmes tranchées 118 qui définissent donc le pas de tous les pixels de cette matrice. La figure 16 correspond à une vue de dessus d'un tel exemple de réalisation. Cet autre exemple de réalisation est très avantageux car dans tous les pixels de la matrice, il n'y a pas d'endommagement des flancs latéraux des portions des couches 108 et 110.

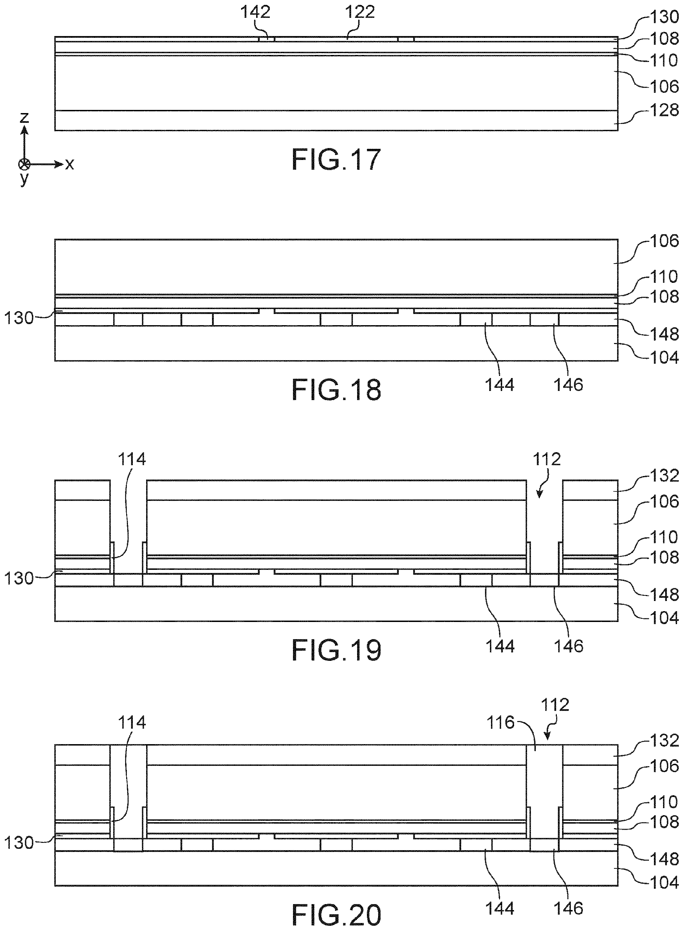

Un procédé de réalisation du dispositif 100 selon un troisième mode de réalisation est décrit ci-dessous en lien avec les figures 17 à 22.

Un empilement similaire à celui précédemment décrit en lien avec la figure 5 est réalisé sur le substrat 128. Les espaces gravés entre les portions électriquement conductrices 122 sont remplis par un matériau diélectrique 142 déposé et planarisé avec arrêt sur les portions 122 (voir figure 17).

Cet ensemble est ensuite reporté et solidarisé au support 104. Préalablement à ce report, des premiers contacts électriques 144 sont réalisés sur le support 104 et sont destinés à être reliés aux portions électriquement conductrices 122. Des deuxièmes contacts électriques 146 sont également réalisés sur le support 104 et sont destinés à être reliés aux premières portions électriquement conductrices 116. Les premiers et deuxièmes contacts électriques 144, 146 sont reliés au circuit électronique de commande du support 104 et sont isolés électriquement les uns des autres par un matériau diélectrique 148 déposé entre ces contacts (voir figure 18).

Après le report de l'empilement de couches 106, 108, 110, 130, le substrat 128 est retiré.

Le masque dur 132 est ensuite réalisé sur l'empilement, puis les premières tranchées 112 sont gravées à travers toute l'épaisseur des couches 106, 108, 110, jusqu'à atteindre les premiers contacts électrique 146.

Les portions diélectriques 114 sont ensuite réalisées dans les premières tranchées 112, contre les flancs latéraux des couches 108, 110 et sur la première partie de l'épaisseur e₁ de la première couche 106 (voir figure 19). Les portions diélectriques 114 sont par exemple réalisées comme décrit dans le document FR 3 073 669 A1.

Les premières portions électriquement conductrices 116 sont ensuite réalisées dans le volume restant des premières tranchées 112, en mettant en œuvre des étapes similaires à celles précédemment décrites pour les premier et deuxième modes de réalisation (voir figure 20).

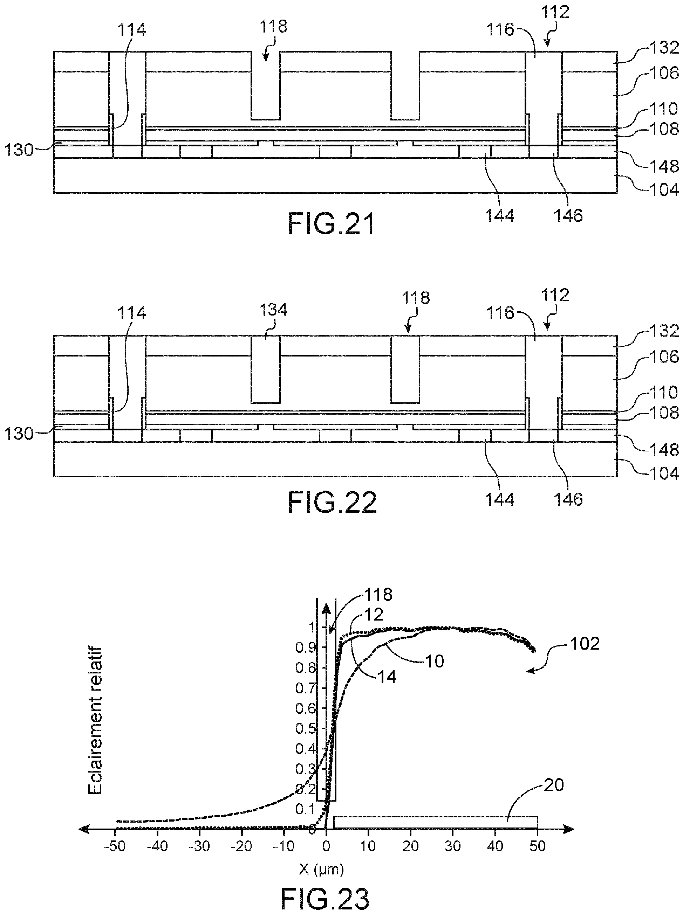

Le motif des deuxièmes tranchées 118 est ensuite gravé dans le masque dur 132, puis à travers une partie de l'épaisseur de la première couche 106 (figure 21).

Le dispositif 100 est ensuite achevé en remplissant les deuxièmes tranchées 118 par au moins un matériau électriquement conducteur formant les deuxièmes portions électriquement conductrices 134 (voir figure 22).

La figure 23 représente des simulations d'éclairement réalisées dans un pixel de GaN défini par des deuxièmes tranchées similaires à celles réalisées au sein du dispositif 100. Cette simulation est obtenue avec un pixel formé dans un empilement de GaN de hauteur égale à 7 µm, avec ces tranchées qui ne traversent pas une partie du GaN d'épaisseur égale à 200 nm. L'émission lumineuse se produit dans la partie de l'épaisseur non traversée par les deuxièmes tranchées 118, qui porte la référence 20 sur la figure 23. La largeur de la deuxième tranchée 118 visible sur la figure 23 est égale à 3 µm. Sur cette figure, la courbe 10 représente l'éclairement relatif obtenu en l'absence de la deuxième tranchée 118, la courbe 12 représente l'éclairement relatif obtenu en présence de la deuxième tranchée 118 lorsque celle-ci n'est pas remplie par un matériau électriquement conducteur et ici remplie par de l'air, et la courbe 14 représente l'éclairement relatif obtenu en présence de la deuxième tranchée 118 lorsque celle-ci est remplie par de l'aluminium formant une deuxième portion électriquement conductrice 134. Ces courbes montrent que même en l'absence de deuxième portion électriquement conductrice 134, les deuxièmes tranchées 118 remplies d'air réalisent une bonne isolation optique entre pixels voisins, cette isolation optique étant encore améliorée en présence des deuxièmes portions électriquement conductrices 134 qui réduisent la diaphonie entre pixels voisins.

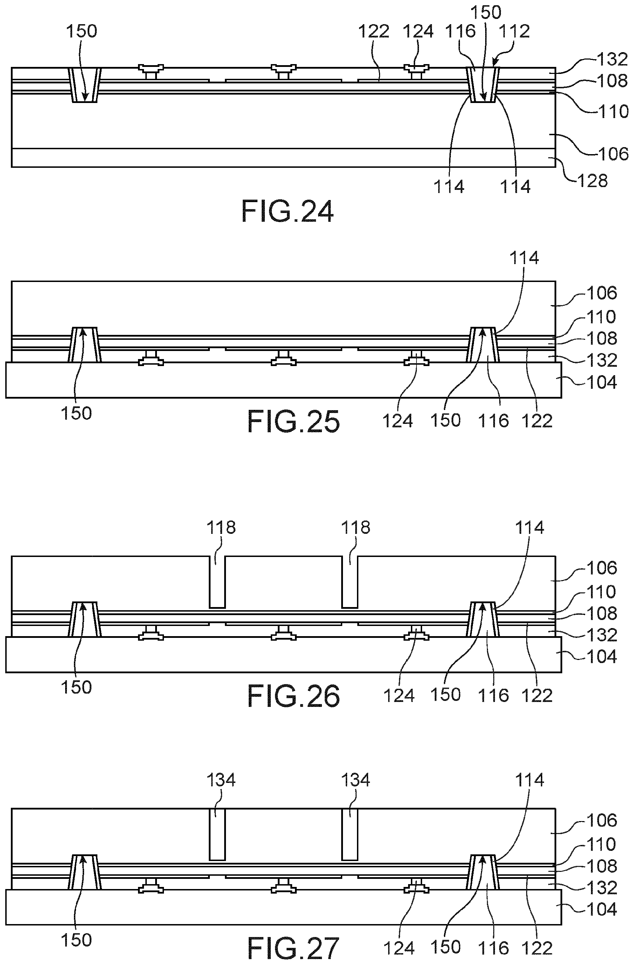

Un procédé de réalisation du dispositif 100 selon un quatrième mode de réalisation est décrit ci-dessous en lien avec les figures 24 à 27.

Comme dans le deuxième mode de réalisation précédemment décrit précédemment en lien avec les figures 13 à 15, les premières tranchées 112 sont gravées, avant le report sur le support 104, partiellement à travers toute l'épaisseur de la couche 130, de la deuxième couche 108 (et de la ou des couches émissives 110 si de telles couches sont présentes dans l'empilement) et à travers une partie seulement (épaisseur e₁) de l'épaisseur de la première couche 106.

Les portions diélectriques 114 et les premières portions électriquement conductrices 116 sont réalisées ensuite dans les premières tranchées 112 qui ne traversent pas toute l'épaisseur de la première couche 106 (voir figure 24). A ce stade du procédé, les premières portions électriquement conductrices 116 sont achevées et sont en contact électriquement avec le matériau de la première couche 106 au niveau des parois de fond 150 des premières tranchées 112.

L'ensemble est ensuite reporté sur le support 104, comme dans le deuxième mode de réalisation (voir figure 25).

Une gravure est ensuite mise en œuvre pour graver les deuxièmes tranchées 118 (voir figure 26).

Les deuxièmes tranchées 118 sont ensuite remplies d'un ou plusieurs matériaux électriquement conducteurs, formant les deuxièmes portions électriquement conductrices 134 (voir figure 27).

Dans ce quatrième mode de réalisation, il est également possible de réaliser un amincissement de la première couche 106 après le retrait du substrat 128.

Dans les exemples et modes de réalisation particuliers décrits ci-dessus, le dispositif 100 comporte une matrice de diodes 102 qui sont des diodes électroluminescentes, le dispositif microélectronique pouvant faire partie d'un dispositif d'affichage à LEDs (écrans, projecteur, mur d'images, etc.). Cette matrice de diodes 102 comporte les premières portions électriquement conductrices 116 qui forment une cathode commune à toutes les diodes 102, et chaque diode 102 comporte une deuxième portion électriquement conductrice 122 formant une anode permettant de réaliser l'adressage individuel de chacune des diodes 102.

En variante, le dispositif microélectronique 100 peut comporter une matrice de diodes 102 qui sont des diodes photo-réceptrices, ou photodiodes. Dans cette variante, les anodes et les cathodes des diodes 102 ne servent pas à fournir du courant aux diodes 102 mais à récupérer les courants photo-générés par les diodes 102.

Selon une autre variante, que les diodes 102 correspondent à des diodes photo-émettrices ou photo-réceptrices, les diodes 102 peuvent ne pas comporter de couches 110 de semi-conducteur intrinsèque entre les première et deuxième couches 106, 108. Dans ce cas, les semi-conducteurs dopés p et n sont alors disposés directement l'un contre l'autre.

Dans tous les exemples et modes de réalisation de l'invention, il est possible de disposer des éléments optiques sur les diodes 102, par exemple des phosphores modifiant la longueur d'onde émise par les diodes 102.

## Revendications

1. Dispositif (100) à matrice de diodes (102) photo-émettrices et/ou photo-réceptrices, comportant au moins :
- un empilement d'au moins une première (106) et une deuxième (108) couches de semi-conducteurs dopés selon des types de conductivité différents, chacune des diodes (102) comportant une portion de la première couche (106) superposée à une portion de la deuxième couche (108) ;
- des premières tranchées (112) traversant toute l'épaisseur de la deuxième couche (108) et au moins une partie de l'épaisseur de la première couche (106) et entourant au moins une région de l'empilement dans laquelle sont formées plusieurs diodes (102) ;
- des portions diélectriques (114) disposées dans les premières tranchées (112) et recouvrant des flancs latéraux de ladite région de l'empilement sur toute l'épaisseur de la deuxième couche (108) et une première partie de l'épaisseur de la première couche (106) ;
- des premières portions électriquement conductrices (116) disposées dans les premières tranchées (112), recouvrant les flancs latéraux de ladite région de l'empilement sur une deuxième partie de l'épaisseur de la première couche (106) non recouverte par les portions diélectriques (114) et/ou recouvrant des parois de fond (150) des premières tranchées (112), et formant au moins une partie de premières électrodes des diodes (102) formées dans ladite région de l'empilement ;
- au moins une deuxième tranchée (118) traversant partiellement l'épaisseur de la première couche (106) depuis une première face (120) de la première couche (106) opposée à une deuxième face de la première couche (106) se trouvant en regard de la deuxième couche (108), et séparant les portions de la première couche (106) des diodes (102) formées dans ladite région de l'empilement sans traverser l'interface entre les première et deuxième couches (106, 108) ;
- plusieurs deuxièmes électrodes (122, 124) isolées électriquement les unes des autres et chacune reliée électriquement à l'une des portions de la deuxième couche (108) des diodes (102) formées dans ladite région de l'empilement ;
et dans lequel les portions de la deuxième couche (108) des diodes (102) formées dans ladite région de l'empilement forment une portion de semi-conducteur continue qui n'est pas traversée par les premières et deuxième tranchées (112, 118).

2. Dispositif (100) selon la revendication 1, comportant en outre au moins une deuxième portion électriquement conductrice (134) disposée dans la deuxième tranchée (118).

3. Dispositif (100) selon la revendication 2, dans lequel la deuxième portion électriquement conductrice (134) est couplée électriquement aux premières portions électriquement conductrices (116) et forme, avec les premières portions électriquement conductrices (116), les premières électrodes des diodes (102).

4. Dispositif (100) selon la revendication 3, dans lequel :
- toutes les diodes (102) de la matrice sont formées dans ladite région de l'empilement, et
- chacune des diodes (102) de la matrice est séparée d'une ou plusieurs diodes (102) voisines par au moins une des deuxièmes tranchées (118).

5. Dispositif (100) selon l'une des revendications 1 à 3, dans lequel :
- les premières tranchées (112) entourent plusieurs régions de l'empilement dans lesquelles les diodes (102) de la matrice sont formées, et
- une ou plusieurs de ces régions comportent chacune la deuxième tranchée (118) ou plusieurs deuxièmes tranchées (118).

6. Dispositif (100) selon la revendication 5, dans lequel la ou les régions de l'empilement comportant la ou les deuxièmes tranchées (118) forment une partie centrale de la matrice de diodes (102).

7. Dispositif (100) selon l'une des revendications précédentes, comportant en outre un circuit électronique de contrôle sur lequel l'empilement des première et deuxième couches (106, 108) est disposé et auquel les premières et deuxièmes électrodes des diodes (102) sont couplées électriquement.

8. Dispositif (100) selon l'une des revendications précédentes, dans lequel :
- les diodes (102) correspondent à des photodiodes, l'empilement comportant en outre au moins une couche (110) de semi-conducteur intrinsèque disposée entre les première et deuxième couches (106, 108) et telle que des flancs latéraux de la couche (110) de semi-conducteur intrinsèque présents dans les premières tranchées (112) soient recouverts par les portions diélectriques (114), les deuxièmes tranchées (118) ne traversant pas la couche (110) de semi-conducteur intrinsèque, ou
- les diodes (102) correspondent à des diodes électroluminescentes, LED, l'empilement comportant
au moins une couche (110) émissive à puits quantique disposée entre les première et deuxième couches (106, 108) et telle que des flancs latéraux de la couche émissive (110) présents dans les premières tranchées (112) soient recouverts par les portions diélectriques (114), les deuxièmes tranchées (118) ne traversant pas la couche émissive (110).

9. Procédé de réalisation d'un dispositif (100) à matrice de diodes (102) photo-émettrices et/ou photo-réceptrices, comportant au moins les étapes de :
- réalisation d'un empilement d'au moins une première et une deuxième couches (106, 108) de semi-conducteurs dopés selon des types de conductivité différents, chacune des diodes (102) étant destinée à comporter une portion de la première couche (106) superposée à une portion de la deuxième couche (108) ;
- réalisation de plusieurs deuxièmes électrodes (122, 124) isolées électriquement les unes des autres et chacune reliée électriquement à l'une des portions de la deuxième couche (108) des diodes (102) destinées à être formées dans ladite région de l'empilement ;
- réalisation de premières tranchées (112) traversant toute l'épaisseur de la deuxième couche (108) et au moins une partie de l'épaisseur de la première couche (106) et entourant au moins une région de l'empilement dans laquelle plusieurs diodes (102) sont destinées à être formées ;
- réalisation de portions diélectriques (114) disposées dans les premières tranchées (112) et recouvrant des flancs latéraux de ladite région de l'empilement sur toute l'épaisseur de la deuxième couche (108) et une première partie de l'épaisseur de la première couche (106) ;
- réalisation de premières portions électriquement conductrices (116) disposées dans les premières tranchées (112), recouvrant les flancs latéraux de ladite région de l'empilement sur une deuxième partie de l'épaisseur de la première couche (106) non recouverte par les portions diélectriques (114) et/ou recouvrant des parois de fond (150) des premières tranchées (112), et formant au moins une partie de premières électrodes des diodes (102) destinées à être formées dans ladite région de l'empilement ;
- réalisation d'au moins une deuxième tranchée (118) traversant partiellement l'épaisseur de la première couche (106) depuis une première face (120) de la première couche (106) opposée à une deuxième face de la première couche (106) se trouvant en regard de la deuxième couche (108), et séparant les portions de la première couche (106) des diodes (102) formées dans ladite région de l'empilement sans traverser l'interface entre les première et deuxième couches (106, 108) ;
et dans lequel les portions de la deuxième couche (108) des diodes (102) formées dans ladite région de l'empilement forment une portion de semi-conducteur continue qui n'est pas traversée par les premières et deuxième tranchées (112, 118).

10. Procédé selon la revendication 9, dans lequel l'empilement est réalisé par épitaxie sur un substrat (128) tel que la première couche (106) soit disposée entre le substrat (128) et la deuxième couche (108).

11. Procédé selon la revendication 10, dans lequel les premières tranchées (112), les portions diélectriques (114) et les premières portions électriquement conductrices (116) sont réalisées en mettant en œuvre les étapes suivantes :
- après la réalisation des deuxièmes électrodes, première gravure de l'empilement à travers la deuxième couche (108) et la première partie de l'épaisseur de la première couche (106), selon un motif définissant les premières tranchées (112), formant des premières parties des premières tranchées (112), puis
- réalisation des portions diélectriques (114) recouvrant les flancs latéraux des premières parties des premières tranchées (112), puis
- deuxième gravure de l'empilement à travers au moins une partie d'une épaisseur restante de la première couche (106) et selon le motif définissant les premières tranchées (112), achevant la réalisation des premières tranchées (112), puis
- dépôt d'au moins un matériau électriquement conducteur dans les premières tranchées (112), formant les premières portions électriquement conductrices (116).

12. Procédé selon l'une des revendications 10 et 11, comportant en outre, après la réalisation des premières portions électriquement conductrices (116) et avant la réalisation de la deuxième tranchée (118), la mise en œuvre des étapes suivantes :
- solidarisation de l'empilement à un support (104) tel que l'empilement soit disposé entre le substrat (128) et le support (104), puis
- retrait du substrat (128).

13. Procédé selon la revendication 10, dans lequel les premières tranchées (112), les portions diélectriques (114), les premières portions électriquement conductrices (116) et la deuxième tranchée (118) sont réalisées en mettant en œuvre les étapes suivantes :
- après la réalisation des deuxièmes électrodes, première gravure de l'empilement à travers la deuxième couche (108) et une partie de l'épaisseur de la première couche (106), selon un motif définissant les premières tranchées (112), formant des premières parties des premières tranchées (112), puis
- réalisation des portions diélectriques (114) recouvrant les flancs latéraux des premières parties des premières tranchées (112), puis
- dépôt d'au moins un matériau électriquement conducteur dans les premières parties des premières tranchées (112), formant des premières parties des premières portions électriquement conductrices (116), puis
- solidarisation de l'empilement à un support (104) tel que l'empilement soit disposé entre le substrat (128) et le support (104), puis
- retrait du substrat (128), révélant la première face (120) de la première couche (106), puis
- deuxième gravure de l'empilement à travers la première face (120) de la première couche (106) et selon un motif définissant les premières et les deuxième tranchées (112, 118), avec arrêt sur les premières parties des premières portions électriquement conductrices (116), formant des deuxièmes parties des premières tranchées (112) et la deuxième tranchée (118), puis
- dépôt du matériau électriquement conducteur dans les deuxièmes parties des premières tranchées (112) et dans la deuxième tranchée (118), achevant la réalisation des premières portions électriquement conductrices (116) et d'au moins une deuxième portion électriquement conductrice (134) disposée dans la deuxième tranchée (118).

14. Procédé selon la revendication 10, dans lequel les premières tranchées (112), les portions diélectriques (114), les premières portions électriquement conductrices (116) et la deuxième tranchée (118) sont réalisées en mettant en œuvre les étapes suivantes :
- après la réalisation des deuxièmes électrodes, solidarisation de l'empilement à un support (104) tel que l'empilement soit disposé entre le substrat (128) et le support (104), puis
- retrait du substrat (128), révélant la première face (120) de la première couche (106), puis
- première gravure de l'empilement à travers les première et deuxième couches (106, 108), selon un motif définissant les premières tranchées (112), formant les premières tranchées (112), puis
- réalisation des portions diélectriques (114) recouvrant les flancs latéraux des premières parties des premières tranchées (112), puis
- dépôt d'au moins un matériau électriquement conducteur dans les premières tranchées (112), formant les premières portions électriquement conductrices (116), puis
- deuxième gravure de l'empilement à travers une partie de l'épaisseur de la première couche (106) et selon un motif définissant la deuxième tranchée (118), formant la deuxième tranchée (118).

15. Procédé selon la revendication 10, dans lequel les premières tranchées (112), les portions diélectriques (114), les premières portions électriquement conductrices (116) et la deuxième tranchée (118) sont réalisées en mettant en œuvre les étapes suivantes :
- après la réalisation des deuxièmes électrodes, première gravure de l'empilement à travers la deuxième couche (108) et la première partie de l'épaisseur de la première couche (106) selon un motif définissant les premières tranchées (112), formant les premières tranchées (112), puis
- réalisation des portions diélectriques (114) recouvrant les flancs latéraux des premières tranchées (112), puis
- dépôt d'au moins un matériau électriquement conducteur dans les premières tranchées (112), formant les premières portions électriquement conductrices (116) qui recouvrent les parois de fond (150) des premières tranchées (112), puis
- solidarisation de l'empilement à un support (104) tel que l'empilement soit disposé entre le substrat (128) et le support (104), puis
- retrait du substrat (128), révélant la première face (120) de la première couche (106), puis
- deuxième gravure de l'empilement à travers la première face (120) de la première couche (106) et selon un motif définissant la deuxième tranchée (118), formant la deuxième tranchée (118).

## Patentansprüche

1. Vorrichtung (100) mit einer Matrix aus lichtemittierenden und/oder lichtempfangenden Dioden (102), die mindestens umfasst:
- einen Stapel aus mindestens einer ersten (106) und einer zweiten (108) Schicht aus Halbleitern, die gemäß unterschiedlichen Leitfähigkeitstypen dotiert sind, wobei jede der Dioden (102) einen Abschnitt der ersten Schicht (106) umfasst, der einem Abschnitt der zweiten Schicht (108) überlagert ist;
- erste Gräben (112), die durch die gesamte Dicke der zweiten Schicht (108) und mindestens einen Teil der Dicke der ersten Schicht (106) hindurchgehen und mindestens eine Region des Stapels, in der mehrere Dioden (102) gebildet sind, umgeben;
- dielektrische Abschnitte (114), die in den ersten Gräben (112) angeordnet sind und Seitenflanken der Region des Stapels über die gesamte Dicke der zweiten Schicht (108) und einen ersten Teil der Dicke der ersten Schicht (106) bedecken;
- erste elektrisch leitende Abschnitte (116), die in den ersten Gräben (112) angeordnet sind, die Seitenflanken der Region des Stapels über einen zweiten Teil der Dicke der ersten Schicht (106), der nicht von den dielektrischen Abschnitten (114) bedeckt ist, bedecken und/oder Bodenwände (150) der ersten Gräben (112) bedecken, und mindestens einen Teil von ersten Elektroden der Dioden (102), die in der Region des Stapels gebildet sind, bilden;
- mindestens einen zweiten Graben (118), der von einer ersten Seite (120) der ersten Schicht (106), die einer der zweiten Schicht (108) zugewandten zweiten Seite der ersten Schicht (106) gegenüberliegt, teilweise durch die Dicke der ersten Schicht (106) hindurchgeht und die Abschnitte der ersten Schicht (106) der in der Region des Stapels gebildeten Dioden (102) trennt, ohne durch die Grenzfläche zwischen der ersten und der zweiten Schicht (106, 108) hindurchzugehen;
- mehrere zweite Elektroden (122, 124), die elektrisch voneinander isoliert sind und jeweils elektrisch mit einem der Abschnitte der zweiten Schicht (108) der in der Region des Stapels gebildeten Dioden (102) verbunden sind;
und wobei die Abschnitte der zweiten Schicht (108) der in der Region des Stapels gebildeten Dioden (102) einen durchgängigen Halbleiterabschnitt bilden, durch den die ersten und der zweite Graben (112, 118) nicht hindurchgehen.

2. Vorrichtung (100) nach Anspruch 1, die weiter mindestens einen zweiten elektrisch leitenden Abschnitt (134) umfasst, der im zweiten Graben (118) angeordnet ist.

3. Vorrichtung (100) nach Anspruch 2, wobei der zweite elektrisch leitende Abschnitt (134) elektrisch mit den ersten elektrisch leitenden Abschnitten (116) gekoppelt ist und zusammen mit den ersten elektrisch leitenden Abschnitten (116) die ersten Elektroden der Dioden (102) bildet.

4. Vorrichtung (100) nach Anspruch 3, wobei:
- alle Dioden (102) der Matrix in der Region des Stapels gebildet sind, und
- jede der Dioden (102) der Matrix durch mindestens einen der zweiten Gräben (118) von einer oder mehreren benachbarten Dioden (102) getrennt ist.

5. Vorrichtung (100) nach einem der Ansprüche 1 bis 3, wobei:
- die ersten Gräben (112) mehrere Regionen des Stapels, in denen die Dioden (102) der Matrix gebildet sind, umgeben, und
- eine oder mehrere dieser Regionen jeweils den zweiten Graben (118) oder mehrere zweite Gräben (118) umfassen.

6. Vorrichtung (100) nach Anspruch 5, wobei die Region(en) des Stapels, die den oder die zweiten Gräben (118) umfasst bzw. umfassen, einen zentralen Teil der Dioden- (102) Matrix bilden.

7. Vorrichtung (100) nach einem der vorstehenden Ansprüche, die weiter eine elektronische Steuerschaltung umfasst, auf der der Stapel der ersten und der zweiten Schicht (106, 108) angeordnet ist und mit der die ersten und die zweiten Elektroden der Dioden (102) elektrisch gekoppelt sind.

8. Vorrichtung (100) nach einem der vorstehenden Ansprüche, wobei:
- die Dioden (102) Photodioden entsprechen, wobei der Stapel weiter mindestens eine intrinsische Halbleiterschicht (110) umfasst, die zwischen der ersten und der zweiten Schicht (106, 108) und so angeordnet ist, dass Seitenflanken der intrinsischen Halbleiterschicht (110), die in den ersten Gräben (112) vorliegen, von den dielektrischen Abschnitten (114) bedeckt sind, wobei die zweiten Gräben (118) nicht durch die intrinsische Halbleiterschicht (110) hindurchgehen, oder
- die Dioden (102) Leuchtdioden, LED, entsprechen, wobei der Stapel mindestens eine emittierende Quantentopfschicht (110) umfasst, die zwischen der ersten und der zweiten Schicht (106, 108) und so angeordnet ist, dass Seitenflanken der emittierenden Schicht (110), die in den ersten Gräben (112) vorliegen, von den dielektrischen Abschnitten (114) bedeckt sind, wobei die zweiten Gräben (118) nicht durch die emittierende Schicht (110) hindurchgehen.

9. Verfahren zur Herstellung einer Vorrichtung (100) mit einer Matrix aus lichtemittierenden und/oder lichtempfangenden Dioden (102), das mindestens die folgenden Schritte umfasst:
- Herstellen eines Stapels aus mindestens einer ersten und einer zweiten Schicht (106, 108) aus Halbleitern, die gemäß unterschiedlichen Leitfähigkeitstypen dotiert sind, wobei jede der Dioden (102) einen Abschnitt der ersten Schicht (106) enthalten soll, der einem Abschnitt der zweiten Schicht (108) überlagert ist;
- Herstellen von mehreren zweiten Elektroden (122, 124), die elektrisch voneinander isoliert sind und jeweils elektrisch mit einem der Abschnitte der zweiten Schicht (108) der Dioden (102), die in der Region des Stapels gebildet werden sollen, verbunden sind;
- Herstellen von ersten Gräben (112), die durch die gesamte Dicke der zweiten Schicht (108) und mindestens einen Teil der Dicke der ersten Schicht (106) hindurchgehen und mindestens eine Region des Stapels, in der mehrere Dioden (102) gebildet werden sollen, umgeben;
- Herstellen von dielektrischen Abschnitten (114), die in den ersten Gräben (112) angeordnet sind und Seitenflanken der Region des Stapels über die gesamte Dicke der zweiten Schicht (108) und einen ersten Teil der Dicke der ersten Schicht (106) bedecken;
- Herstellen von ersten elektrisch leitenden Abschnitten (116), die in den ersten Gräben (112) angeordnet sind, die Seitenflanken der Region des Stapels über einen zweiten Teil der Dicke der ersten Schicht (106), der nicht von den dielektrischen Abschnitten (114) bedeckt ist, bedecken und/oder Bodenwände (150) der ersten Gräben (112) bedecken, und mindestens einen Teil von ersten Elektroden der Dioden (102), die in der Region des Stapels gebildet werden sollen, bilden;
- Herstellen von mindestens einem zweiten Graben (118), der von einer ersten Seite (120) der ersten Schicht (106), die einer der zweiten Schicht (108) zugewandten zweiten Seite der ersten Schicht (106) gegenüberliegt, teilweise durch die Dicke der ersten Schicht (106) hindurchgeht und die Abschnitte der ersten Schicht (106) der in der Region des Stapels gebildeten Dioden (102) trennt, ohne durch die Grenzfläche zwischen der ersten und der zweiten Schicht (106, 108) hindurchzugehen;
und wobei die Abschnitte der zweiten Schicht (108) der in der Region des Stapels gebildeten Dioden (102) einen durchgängigen Halbleiterabschnitt bilden, durch den die ersten und der zweite Graben (112, 118) nicht hindurchgehen.

10. Verfahren nach Anspruch 9, wobei der Stapel durch Epitaxie auf einem Substrat (128) so hergestellt wird, dass die erste Schicht (106) zwischen dem Substrat (128) und der zweiten Schicht (108) angeordnet ist.

11. Verfahren nach Anspruch 10, wobei die ersten Gräben (112), die dielektrischen Abschnitte (114) und die ersten elektrisch leitenden Abschnitte (116) hergestellt werden, indem die folgenden Schritte umgesetzt werden:
- nach dem Herstellen der zweiten Elektroden, erstes Ätzen des Stapels durch die zweite Schicht (108) und den ersten Teil der Dicke der ersten Schicht (106) hindurch gemäß einem die ersten Gräben (112) definierenden Muster, wodurch erste Teile der ersten Gräben (112) gebildet werden, und anschließend
- Herstellen der dielektrischen Abschnitte (114), die die Seitenflanken der ersten Teile der ersten Gräben (112) bedecken, und anschließend
- zweites Ätzen des Stapels durch mindestens einen Teil einer verbleibenden Dicke der ersten Schicht (106) hindurch und gemäß dem die ersten Gräben (112) definierenden Muster, wodurch die Herstellung der ersten Gräben (112) vollendet wird, und anschließend
- Abscheiden mindestens eines elektrisch leitenden Materials in den ersten Gräben (112), wodurch die ersten elektrisch leitenden Abschnitte (116) gebildet werden.

12. Verfahren nach einem der Ansprüche 10 und 11, das nach dem Herstellen der ersten elektrisch leitenden Abschnitte (116) und vor dem Herstellen des zweiten Grabens (118) weiter das Umsetzen der folgenden Schritte umfasst:
- Befestigen des Stapels an einem Träger (104) so, dass der Stapel zwischen dem Substrat (128) und dem Träger (104) angeordnet ist, und anschließend
- Entfernen des Substrats (128).

13. Verfahren nach Anspruch 10, wobei die ersten Gräben (112), die dielektrischen Abschnitte (114), die ersten elektrisch leitenden Abschnitte (116) und der zweite Graben (118) hergestellt werden, indem die folgenden Schritte umgesetzt werden:
- nach dem Herstellen der zweiten Elektroden, erstes Ätzen des Stapels durch die zweite Schicht (108) und einen Teil der Dicke der ersten Schicht (106) hindurch gemäß einem die ersten Gräben (112) definierenden Muster, wodurch erste Teile der ersten Gräben (112) gebildet werden, und anschließend
- Herstellen der dielektrischen Abschnitte (114), die die Seitenflanken der ersten Teile der ersten Gräben (112) bedecken, und anschließend
- Abscheiden mindestens eines elektrisch leitenden Materials in den ersten Teilen der ersten Gräben (112), wodurch erste Teile der ersten elektrisch leitenden Abschnitte (116) gebildet werden, und anschließend
- Befestigen des Stapels an einem Träger (104) so, dass der Stapel zwischen dem Substrat (128) und dem Träger (104) angeordnet ist, und anschließend
- Entfernen des Substrats (128), wodurch die erste Seite (120) der ersten Schicht (106) freigelegt wird, und anschließend
- zweites Ätzen des Stapels durch die erste Seite (120) der ersten Schicht (106) hindurch und gemäß einem die ersten und die zweiten Gräben (112, 118) definierenden Muster, mit Stopp an den ersten Teilen der ersten elektrisch leitenden Abschnitte (116), wodurch zweite Teile der ersten Gräben (112) und der zweite Graben (118) gebildet werden, und anschließend
- Abscheiden des elektrisch leitenden Materials in den zweiten Teilen der ersten Gräben (112) und im zweiten Graben (118), wodurch die Herstellung der ersten elektrisch leitenden Abschnitte (116) und mindestens eines im zweiten Graben (118) angeordneten zweiten elektrisch leitenden Abschnitts (134) vollendet wird.

14. Verfahren nach Anspruch 10, wobei die ersten Gräben (112), die dielektrischen Abschnitte (114), die ersten elektrisch leitenden Abschnitte (116) und der zweite Graben (118) hergestellt werden, indem die folgenden Schritte umgesetzt werden:
- nach dem Herstellen der zweiten Elektroden, Befestigen des Stapels an einem Träger (104) so, dass der Stapel zwischen dem Substrat (128) und dem Träger (104) angeordnet ist, und anschließend
- Entfernen des Substrats (128), wodurch die erste Seite (120) der ersten Schicht (106) freigelegt wird, und anschließend
- erstes Ätzen des Stapels durch die erste und die zweite Schicht (106, 108) hindurch gemäß einem die ersten Gräben (112) definierenden Muster, wodurch die ersten Gräben (112) gebildet werden, und anschließend
- Herstellen der dielektrischen Abschnitte (114), die die Seitenflanken der ersten Teile der ersten Gräben (112) bedecken, und anschließend
- Abscheiden mindestens eines elektrisch leitenden Materials in den ersten Gräben (112), wodurch die ersten elektrisch leitenden Abschnitte (116) gebildet werden, und anschließend
- zweites Ätzen des Stapels durch einen Teil der Dicke der ersten Schicht (106) hindurch und gemäß einem den zweiten Graben (118) definierenden Muster, wodurch der zweite Graben (118) gebildet wird.

15. Verfahren nach Anspruch 10, wobei die ersten Gräben (112), die dielektrischen Abschnitte (114), die ersten elektrisch leitenden Abschnitte (116) und der zweite Graben (118) hergestellt werden, indem die folgenden Schritte umgesetzt werden:
- nach dem Herstellen der zweiten Elektroden, erstes Ätzen des Stapels durch die zweite Schicht (108) und den ersten Teil der Dicke der ersten Schicht (106) hindurch gemäß einem die ersten Gräben (112) definierenden Muster, wodurch die ersten Gräben (112) gebildet werden, und anschließend
- Herstellen der dielektrischen Abschnitte (114), die die Seitenflanken der ersten Gräben (112) bedecken, und anschließend
- Abscheiden mindestens eines elektrisch leitenden Materials in den ersten Gräben (112), wodurch die ersten elektrisch leitenden Abschnitte (116) gebildet werden, die die Bodenwände (150) der ersten Gräben (112) bedecken, und anschließend
- Befestigen des Stapels an einem Träger (104) so, dass der Stapel zwischen dem Substrat (128) und dem Träger (104) angeordnet ist, und anschließend
- Entfernen des Substrats (128), sodass die erste Seite (120) der ersten Schicht (106) freigelegt wird, und anschließend
- zweites Ätzen des Stapels durch die erste Seite (120) der ersten Schicht (106) hindurch und gemäß einem den zweiten Graben (118) definierenden Muster, wodurch der zweite Graben (118) gebildet wird.

## Claims

1. Photo-emitting and/or photo-receiving diode (102) array device (100), comprising at least:
- a stack of at least one first (106) and one second (108) semiconductor layers doped according to different types of conductivity, each one of the diodes (102) comprising a portion of the first layer (106) superimposed on a portion of the second layer (108);
- first trenches (112) passing through the entire thickness of the second layer (108) and at least one part of the thickness of the first layer (106) and surrounding at least one region of the stack wherein several diodes (102) are formed;
- dielectric portions (114) arranged in the first trenches (112) and covering the lateral flanks of said region of the stack over the entire thickness of the second layer (108) and a first part of the thickness of the first layer (106);
- first electrically conductive portions (116) arranged in the first trenches (112), covering the lateral flanks of said region of the stack over a second part of the thickness of the first layer (106) not covered by the dielectric portions (114) and/or covering bottom walls (150) of the first trenches (112), and forming at least one part of the first electrodes of the diodes (102) formed in said region of the stack;
- at least one second trench (118) partially passing through the thickness of the first layer (106) from a first face (120) of the first layer (106) opposite a second face of the first layer (106) facing the second layer (108), and separating the portions of the first layer (106) from the diodes (102) formed in said region of the stack without passing through the interface between the first and second layers;
- several second electrodes (122, 124) electrically insulated from one another and each one electrically connected to one of the portions of the second layer (108) of the diodes (102) formed in said region of the stack;
and wherein the portions of the second layer (108) of the diodes (102) formed in said region of the stack form a continuous semiconductor portion which is not crossed by the first and second trenches (112, 118).

2. Device (100) according to claim 1, further comprising at least one second electrically conductive portion (134) arranged in the second trench (118).

3. Device (100) according to claim 2, wherein the second electrically conductive portion (134) is electrically coupled to the first electrically conductive portions (116) and forms, with the first electrically conductive portions (116), the first electrodes of the diodes (102).

4. Device (100) according to claim 3, wherein:
- all the diodes (102) of the array are formed in said region of the stack, and
- each one of the diodes (102) of the array is separated from one or more adjacent diodes (102) by at least one of the second trenches (118).

5. Device (100) according to one of claims 1 to 3, wherein:
- the first trenches (112) surround several regions of the stack wherein the diodes (102) of the array are formed, and
- one or more of these regions each comprise the second trench (118) or several second trenches (118).

6. Device (100) according to claim 5, wherein the region or regions of the stack comprising the second trench or trenches (118) form a central part of the diode array (102).

7. Device (100) according to one of the previous claims, further comprising an electronic control circuit whereon the stack of the first and second layers (106, 108) is arranged and to which the first and second electrodes of the diodes (102) are electrically coupled.

8. Device (100) according to one of previous claims, wherein:
- the diodes (102) correspond to photodiodes, the stack further comprising at least one intrinsic semiconductor layer (110) arranged between the first and second layers (106, 108) and such that lateral flanks of the intrinsic semiconductor layer (110) present in the first trenches (112) are covered by the dielectric portions (114), the second trenches (118) not passing through the intrinsic semiconductor layer (110), or
- the diodes (102) correspond to LEDs, the stack comprising at least one quantum well emissive layer (110) arranged between the first and second layers (106, 108) and such that lateral flanks of the emissive layer (110) present in the first trenches (112) are covered by the dielectric portions (114), the second trenches (118) not passing through the emissive layer (110).

9. Method for producing a photo-emitting and/or photo-receiving diode (102) array device (100), comprising at least the steps of:
- producing a stack of at least one first and one second semiconductor layers (106, 108) doped according to different types of conductivity, each one of the diodes (102) being intended to comprise a portion of the first layer (106) superimposed on a portion of the second layer (108);
- producing several second electrodes (122, 124) electrically insulated from one another and each one electrically connected to one of the portions of the second layer (108) of the diodes (102) intended to be formed in said region of the stack;
- producing first trenches (112) passing through the entire thickness of the second layer (108) and at least one part of the thickness of the first layer (106) and surrounding at least one region of the stack wherein several diodes (102) are intended to be formed;
- producing dielectric portions (114) arranged in the first trenches (112) and covering the lateral flanks of said region of the stack over the entire thickness of the second layer (108) and a first part of the thickness of the first layer (106);
- producing first electrically conductive portions (116) arranged in the first trenches (112), covering the lateral flanks of said region of the stack over a second part of the thickness of the first layer (106) not covered by the dielectric portions (114) and/or covering bottom walls (150) of the first trenches (112), and forming at least one part of the first electrodes of the diodes (102) intended to be formed in said region of the stack;
- producing at least one second trench (118) partially passing through the thickness of the first layer (106) from a first face (120) of the first layer (106) opposite to a second face of the first layer (106) facing the second layer (108), and separating the portions of the first layer (106) from the diodes (102) formed in said region of the stack without passing through the interface between the first and second layers (106, 108);
and wherein the portions of the second layer (108) of the diodes (102) produced in said region of the stack form a continuous semiconductor portion which is not crossed by the first and second trenches (112, 118).

10. Method according to claim 9, wherein the stack is produced by epitaxy on a substrate (128) such that the first layer (106) is arranged between the substrate (128) and the second layer (108).

11. Method according to claim 10, wherein the first trenches (112), the dielectric portions (114) and the first electrically conductive portions (116) are produced by implementing the following steps:
- after producing the second electrodes, first etching of the stack through the second layer (108) and the first part of the thickness of the first layer (106), according to a pattern defining the first trenches (112), forming first parts of the first trenches (112), then
- producing dielectric portions (114) covering the lateral flanks of the first parts of the first trenches (112), then
- second etching of the stack through at least one part of a remaining thickness of the first layer (106) and according to the pattern defining the first trenches (112), completing the producing of the first trenches (112), then
- deposition of at least one electrically conductive material in the first trenches (112), forming the first electrically conductive portions (116).

12. Method according to one of claims 10 and 11, further comprising, after producing the first electrically conductive portions (116) and before producing the second trench (118), the implementing of the following steps:
- making the stack integral with a support (104) such as the stack is arranged between the substrate (128) and the support (104), then
- removing the substrate (128).

13. Method according to claim 10, wherein the first trenches (112), the dielectric portions (114), the first electrically conductive portions (116) and the second trench (118) are produced by implementing the following steps:
- after producing the second electrodes, first etching of the stack through the second layer (108) and a part of the thickness of the first layer (106), according to a pattern defining the first trenches (112), forming first parts of the first trenches (112), then
- producing dielectric portions (114) covering the lateral flanks of the first parts of the first trenches (112), then
- deposition of at least one electrically conductive material in the first parts of the first trenches (112), forming first parts of the first electrically conductive portions (116), then
- making the stack integral with a support (104) such as the stack is arranged between the substrate (128) and the support (104), then
- removing the substrate (128), exposing the first face (120) of the first layer (106), then
- second etching of the stack through the first face (120) of the first layer (106) and according to a pattern defining the first and the second trenches (112, 118), with stopping on the first parts of the first electrically conductive portions (116), forming second parts of the first trenches (112) and the second trench (118), then
- deposition of the electrically conductive material in the second parts of the first trenches (112) and in the second trench (118), completing the production of the first electrically conductive portions (116) and of at least one second electrically conductive portion (134) arranged in the second trench (118).

14. Method according to claim 10, wherein the first trenches (112), the dielectric portions (114), the first electrically conductive portions (116) and the second trench (118) are produced by implementing the following steps:
- after producing the second electrodes, making the stack integral with a support (104) such as the stack is arranged between the substrate (128) and the support (104), then
- removing the substrate (128), exposing the first face (120) of the first layer (106), then
- first etching of the stack through the first and second layers (106, 108), according to a pattern defining the first trenches (112), forming the first trenches (112), then
- producing dielectric portions (114) covering the lateral flanks of the first parts of the first trenches (112), then
- deposition of at least one electrically conductive material in the first trenches (112), forming the first electrically conductive portions (116), then
- second etching of the stack through a part of the thickness of the first layer (106) and according to a pattern defining the second trench (118), forming the second trench (118).

15. Method according to claim 10, wherein the first trenches (112), the dielectric portions (114), the first electrically conductive portions (116) and the second trench (118) are produced by implementing the following steps:
- after producing the second electrodes, first etching of the stack through the second layer (108) and the first part of the thickness of the first layer (106) according to a pattern defining the first trenches (112), forming the first trenches (112), then
- producing dielectric portions (114) covering the lateral flanks of the first trenches (112), then
- deposition of at least one electrically conductive material in the first trenches (112), forming the first electrically conductive portions (116) that cover the bottom walls (150) of the first trenches (112), then
- making the stack integral with a support (104) such as the stack is arranged between the substrate (128) and the support (104), then
- removing the substrate (128), exposing the first face (120) of the first layer (106), then
- second etching of the stack through the first face (120) of the first layer (106) and according to a pattern defining the second trench (118), forming the second trench (118).
